# EUROPEAN PATENT APPLICATION

(11) **EP 4 583 110 A1**
(43) Date of publication of application: **09.07.2025**
(21) Application number: 24219374.6
(22) Date of filing: 12.12.2024
(51) Int. Cl.: G11C 16/04, G11C 16/08, H10B 43/10, H10B 43/40

(54) **SEMICONDUCTOR DEVICE AND MEMORY DEVICE INCLUDING THE SAME**

(30) Priority: 05.01.2024 KR 20240002304
(71) Applicant: Samsung Electronics Co., Ltd., Suwon-si, Gyeonggi-do 16677 (KR)
(72) Inventor: KIM, Seungyeon, Suwon-si, Gyeonggi-do 16677 (KR); NAM, Hanmin, Suwon-si, Gyeonggi-do 16677 (KR); FUTATSUYAMA, Takuya, Suwon-si, Gyeonggi-do 16677 (KR)
(74) Representative: Kuhnen & Wacker Patent- und Rechtsanwaltsbüro PartG mbB

(57) **Abstract**

A semiconductor device including a substrate (101) having an active region (110) including a central active region (110_1) and a plurality of separate active regions (110_2a, 110_2b, 110_2c, 110_2d), and a plurality of gate structures (120a, 120b, 120c, 120d) disposed above the active region (110), wherein the a plurality of gate structures (120a, 120b, 120c, 120d), the central active region (110_1), and the a plurality of separate active regions (110_2a, 110_2b, 110_2c, 110_2d) constitute a plurality of pass transistors (PTR1, PTR2, PTR3, PTR4), and the plurality of pass transistors (PTR1, PTR2, PTR3, PTR4) share a same source/drain region (D) in the central active region (110_1).

## Description

### BACKGROUND

Apparatuses and methods consistent with embodiments of the present disclosure relate to a semiconductor device and a memory device including the same, and more specifically, to a semiconductor device having a distinctive shape and a wiring structure of a word line connected to the semiconductor device.

Memory devices are used to store data and are divided into volatile memory devices and non-volatile memory devices. The demand for high capacity and miniaturized non-volatile memory devices has led to the development of three-dimensional memory devices in which memory cell arrays and peripheral circuits are arranged in a vertical direction. For high-capacity of non-volatile memory devices, as the number of word lines stacked on a substrate increases, the number of pass transistors connected to the word lines may increase. Accordingly, the number, length, and complexity of connection wirings for connecting between word lines and pass transistors increase, potentially compromising the reliability of memory devices due to issues with coupling between the connection wirings.

### SUMMARY

One or more embodiments provide a semiconductor device capable of improving complexity of a wiring structure of a memory device, and a memory device including the semiconductor device.

According to an aspect of the disclosure, a semiconductor device may include: a substrate having an active region including a central active region and a plurality of separate active regions extending from the central active region; and a plurality of gate structures disposed above the active region, wherein the plurality of gate structures, the central active region, and the plurality of separate active regions constitute a plurality of pass transistors, and the plurality of pass transistors share a same source/drain region in the central active region.

Each of the plurality of gate structures may have a rectangular shape or an L shape.

The active region may have an H shape, in which the central active region has a rectangular shape, two of the plurality of separate active regions extend in one direction from the central active region to be parallel to each other, and the other two of the plurality of separate active regions extend in an opposite direction from the central active region to be parallel to each other.

The active region may have a cross shape in which the central active region has a rectangular shape and is posited at a midpoint of four outer points, and the plurality of separate active regions extend from the midpoint towards the four outer points, respectively, or the active region has a Y shape in which the central active region has a triangle shape and is located at a midpoint of three corner points, and the plurality of separate active regions extend from the midpoint towards the three corner points, respectively.

The semiconductor device may further include: a drain contact connected to the central active region; and a plurality of source contacts of the plurality of pass transistors respectively connected to the plurality of separate active regions.

The drain contact may be connected to a global word line, and the plurality of source contacts may be connected to a plurality of different local word lines.

The plurality of source contacts may be connected to different memory cell blocks, respectively.

According to another aspect of the disclosure, a memory device may include: a plurality of memory blocks including a plurality of memory cells connected to a plurality of word lines stacked in a vertical direction; and a plurality of pass transistor circuit blocks connected to the plurality of memory blocks and arranged in parallel with each other in a second horizontal direction, wherein each of the plurality of pass transistor circuit blocks may include a plurality of semiconductor devices arranged in parallel with each other in a first horizontal direction, each of the plurality of semiconductor devices may include: a substrate having an active region including a central active region and a plurality of separate active regions extending from the central active region; and a plurality of gate structures disposed above the active region, the plurality of gate structures, the central active region, and the plurality of separate active regions constitute a plurality of pass transistors, and the plurality of pass transistors share a same source/drain region in the central active region.

Patterns of the plurality of semiconductor devices may be identical within a same pass transistor circuit block among the plurality of pass transistor circuit blocks.

Patterns of semiconductor devices included in adjacent pass transistor circuit blocks in the second horizontal direction among the plurality of pass transistor circuit blocks may be different from each other.

Semiconductor devices included in adjacent pass transistor circuit blocks that are adjacent to each other in the second horizontal direction among the plurality of pass transistor circuit blocks may be electrically connected to each other via a wiring in the second horizontal direction or in the first horizontal direction.

A global word line connected via a wiring in the second horizontal direction may be connected to the source/drain regions of the semiconductor devices included in each of the plurality of pass transistor circuit blocks arranged adjacent to each other in the second horizontal direction.

The plurality of pass transistor circuit blocks may be electrically connected to each other via a plurality of local word lines, respectively, among the plurality of word lines.

According to another aspect of the disclosure, a memory device may include: a plurality of memory cell blocks arranged in parallel with each other in a second direction; and a plurality of semiconductor devices connected to the plurality of memory cell blocks, wherein the plurality of semiconductor devices are arranged in parallel with each other in the second direction, and N of the plurality of semiconductor devices are arranged in parallel with each other in a first direction, wherein N is a natural number that is greater than or equal to 1, each of the plurality of semiconductor devices may include: a substrate having an active region including a central active region and a plurality of separate active regions extending from the central active region; and a plurality of gate structures disposed above the active region. The plurality of gate structures, the central active region, and the plurality of separate active regions constitute a plurality of pass transistors, and the plurality of pass transistors may share a same source/drain region in the central active region.

A global word line may be connected to the source/drain region of each of the plurality of semiconductor devices, and different local word lines may be connected to the plurality of separate active regions of each of the plurality of semiconductor devices.

The plurality of semiconductor devices arranged in parallel with each other in the second direction may be respectively connected to different global word lines.

Each of the plurality of semiconductor devices arranged in parallel with each other in the second direction may be electrically connected to each other via connection of the different local word lines.

Each of the plurality of semiconductor devices arranged in parallel with each other in the second direction may be electrically connected to each other based on numbers for word line pads respectively corresponding to the plurality of separate active regions and a number for the global word line.

Each of the plurality of semiconductor devices arranged in parallel with each other in the second direction may be electrically connected to each other via wirings in the first direction and/or the second direction.

The wirings in the first direction and/or the second direction may share one or more tracks.

### BRIEF DESCRIPTION OF DRAWINGS

Embodiments will be more clearly understood from the following detailed description taken in conjunction with the accompanying drawings in which:
FIG. 1 is a block diagram of a memory device according to one or more embodiments;
FIG. 2 is an equivalent circuit diagram of a memory cell array of a semiconductor device, according to one or more embodiments;
FIG. 3 illustrates an example of a memory cell array according to one or more embodiments;
FIG. 4 illustrates examples of pass transistor circuit blocks and a memory cell array, according to one or more embodiments;
FIG. 5A is a layout diagram of a semiconductor device according to one or more embodiments;
FIG. 5B is a cross-sectional view taken along a line A-A' of FIG. 5A;
FIG. 5C is a cross-sectional view taken along a line B-B' of FIG. 5A;
FIG. 6 is a layout diagram of a semiconductor device according to one or more embodiments;
FIG. 7 is a layout diagram of a semiconductor device according to one or more embodiments;
FIG. 8 is a layout diagram of a semiconductor device according to one or more embodiments;
FIG. 9A is a diagram describing an arrangement structure of semiconductor devices according to one or more embodiments;
FIG. 9B is a diagram describing an arrangement structure of semiconductor devices according to one or more embodiments;
FIG. 10 is a diagram describing an arrangement structure of semiconductor devices according to one or more embodiments;
FIG. 11 is a diagram describing an example in which semiconductor devices are arranged to correspond to a plurality of block structures, according to one or more embodiments;
FIG. 12 is a diagram describing an example in which semiconductor devices are arranged to correspond to a plurality of block structures, according to one or more embodiments;
FIG. 13 is a diagram describing an example in which semiconductor devices are arranged to correspond to a plurality of block structures, according to one or more embodiments;
FIG. 14 is a diagram describing an example in which semiconductor devices are arranged to correspond to a plurality of block structures, according to one or more embodiments;
FIG. 15 is a diagram describing an example in which semiconductor devices are arranged to correspond to a plurality of block structures, according to one or more embodiments;
FIG. 16 is a diagram describing an example in which semiconductor devices are arranged to correspond to a plurality of block structures, according to one or more embodiments;
FIG. 17 is a diagram describing an example in which semiconductor devices are arranged to correspond to a plurality of block structures, according to one or more embodiments;
FIG. 18 is a diagram describing an example in which semiconductor devices are arranged to correspond to a plurality of block structures, according to one or more embodiments;
FIG. 19 is a diagram describing an example in which semiconductor devices are arranged to correspond to a plurality of block structures, according to one or more embodiments;
FIG. 20 is a diagram describing an example in which semiconductor devices are arranged to correspond to a plurality of block structures, according to one or more embodiments;
FIG. 21 is a diagram describing a connection structure between a semiconductor device and a word line, according to one or more embodiments;
FIG. 22 is a diagram describing a connection structure between a semiconductor device and a word line, according to one or more embodiments;
FIG. 23 is a diagram describing a connection structure between a semiconductor device and a local word line, according to one or more embodiments;
FIG. 24 is a diagram describing a connection structure between a semiconductor device and a global word line, according to one or more embodiments; and
FIG. 25 is a diagram describing a connection structure between a semiconductor device and a global word line, according to one or more embodiments.

### DETAILED DESCRIPTION OF EMBODIMENTS

Hereinafter, various embodiments of the inventive concept will be described with reference to the accompanying drawings.

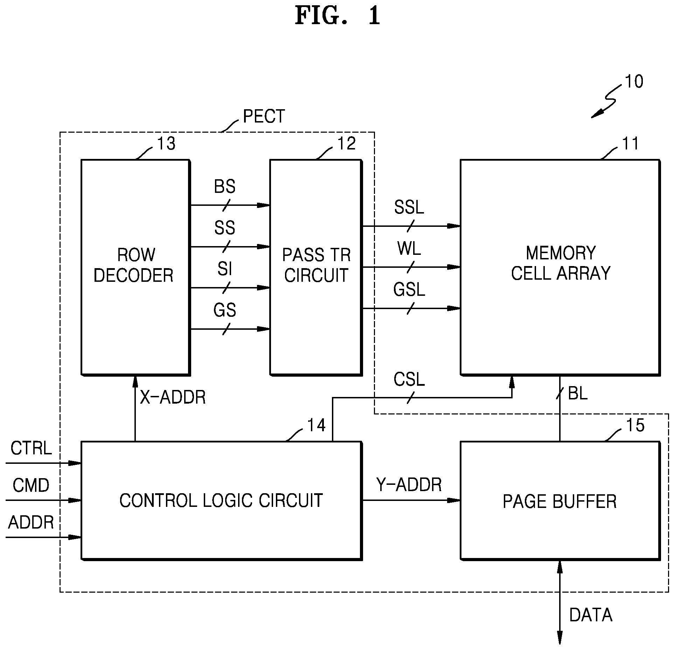

FIG. 1 is a block diagram of a memory device 10 according to one or more embodiments.

Referring to FIG. 1, the memory device 10 may include a memory cell array 11 and a peripheral circuit PECT, wherein the peripheral circuit PECT may include a pass transistor circuit 12, a row decoder 13, a control logic circuit 14, and a page buffer 15. The peripheral circuit PECT may further include a voltage generator, a data input/output circuit, an input/output interface, a temperature sensor, a command decoder, or an address decoder. In some embodiments, the memory device 10 may be a non-volatile memory device, and hereinafter, the term "memory device" may refer to a non-volatile memory device.

The memory cell array 11 may be connected to the pass transistor circuit 12 via word lines WL, string select lines SSL, and ground select lines GSL, and may be connected to a page buffer 15 via bit lines BL. The memory cell array 11 may include a plurality of memory cells, and for example, the memory cells may be flash memory cells. Hereinafter, various embodiments of the present disclosure are described with reference to an example where the plurality of memory cells are NAND flash memory cells. However, the embodiments are not limited thereto, and in some embodiments, the plurality of memory cells may be resistive memory cells, such as resistive RAM (ReRAM), phase change RAM (PRAM), or magnetic RAM (MRAM).

In one or more embodiments, the memory cell array 11 may include a three-dimensional memory cell array, the three-dimensional memory cell may include a plurality of NAND strings, and each of the NAND strings may include memory cells respectively connected to word lines vertically stacked on a substrate. However, the embodiments are not limited thereto, and in some embodiments, the memory cell array 11 may include a two-dimensional memory cell array, and the two-dimensional memory cell array may include a plurality of NAND strings arranged in row and column directions.

The control logic circuit 14 may generate various control signals to program data into the memory cell array 11, read data from the memory cell array 11, or erase data stored in the memory cell array 11, based on a command CMD, an address ADDR, and a control signal CTRL. For example, the control logic circuit 14 may output a row address X-ADDR and a column address Y-ADDR. Accordingly, the control logic circuit 14 may overall control various operations within the memory device 10. In some embodiments, the control logic circuit 14 may include a common source line driver, and the common source line driver may be connected to the memory cell array 11 via a common source line CSL. The common source line driver may apply a common source voltage (e.g., a power voltage) or a ground voltage to the common source line CSL, based on a control signal of the control logic circuit 14.

The row decoder 13 may output a block select signal for selecting one of a plurality of memory blocks through block select signal lines BS, in response to the row address X-ADDR. In addition, in response to the row address X-ADDR, the row decoder 13 may output a word line driving signal for selecting one of word lines WL of the selected memory block through word line driving signal lines SI, output a string select line driving signal for selecting one of the string select lines SSL through string select line driving signal lines SS, and output a ground select line driving signal for selecting one of the ground select lines GSL through ground select line driving signal lines GS. In some embodiments, the word line driving signal lines SI may be referred to as global word lines. The page buffer 15 may select some of the bit lines BL in response to the column address Y-ADDR. Specifically, the page buffer 15 may operate as a write driver or a sense amplifier according to an operation mode. In some embodiments, the word line WL of the selected memory block may be referred to as a local word line.

The pass transistor circuit 12 may be connected to the row decoder 13 via the block select signal lines BS, the string select line driving signal lines SS, the word line driving signal lines SI, and the ground select line driving signal lines GS. The string select line driving signal lines SS, the word line driving signal lines SI, and the ground select line driving signal lines GS may be collectively referred to as driving signal lines. The pass transistor circuit 12 may include a plurality of pass transistors, the plurality of pass transistor may be controlled by block select signals received via the block select signal lines BS, and string select line driving signals, word line driving signals, and ground select line driving signals may be respectively provided to the string select lines SSL, the word lines WL, and the ground select lines GSL.

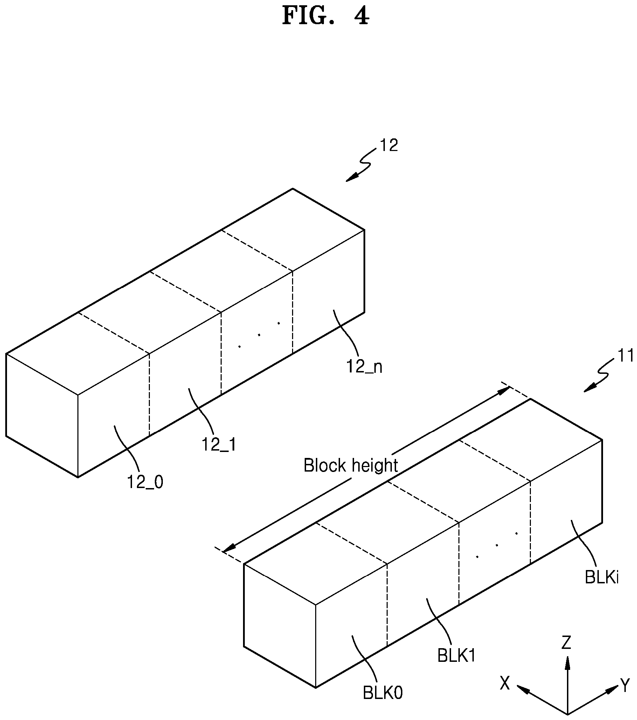

The pass transistor circuit 12 according to one or more embodiments may include a plurality of semiconductor devices arranged in parallel with each other in a first direction and a second direction and having a certain shape. This is to be described in detail below with reference to FIG. 4 and other drawings.

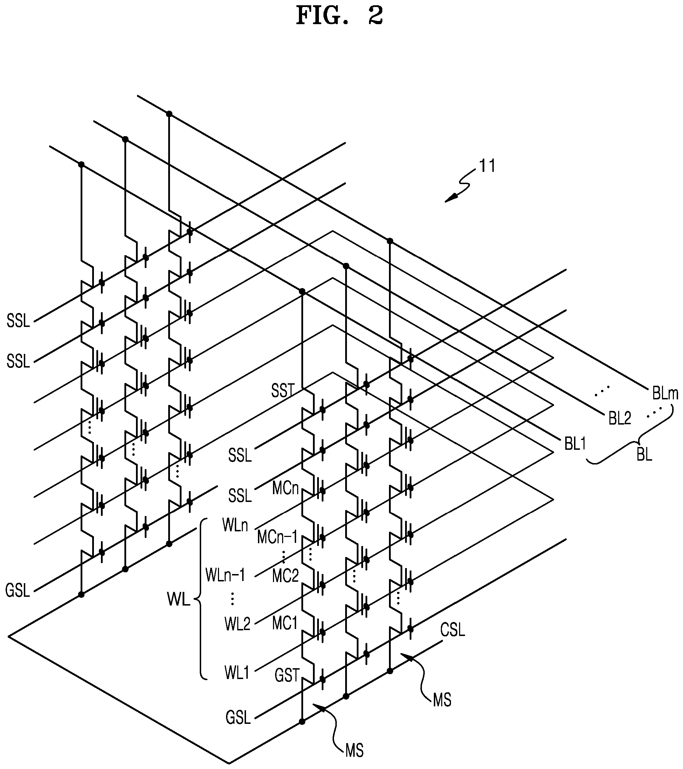

FIG. 2 is an equivalent circuit diagram of the memory cell array 11 of the memory device 10, according to one or more embodiments.

Referring to FIG. 2, the memory cell array 11 may include a plurality of memory cell strings MS. The memory cell array 11 may include a plurality of bit lines BL (BL1, BL2, ..., and BLm), a plurality of word lines WL (WL1, WL2, ..., WLn-1, and WLn), at least one string select line SSL, at least one ground select line GSL, and the common source line CSL. The plurality of memory cell strings MS may be formed between the plurality of bit lines BL (BL1, BL2, ..., and BLm) and the common source line CSL. FIG. 2 illustrates an example where each of the plurality of memory cell strings MS includes two string select lines SSL, but the embodiments are not limited thereto. For example, each of the plurality of memory cell strings MS may include one string select line SSL. For example, each of the plurality of memory cell strings MS may include at least three string select lines SSL.

Each of the plurality of memory cell strings MS may include a string select transistor SST, a ground select transistor GST, and a plurality of memory cell transistors MC1, MC2, ..., MCn-1, and MCn. A drain region of the string select transistor SST may be connected to the bit lines BL (BL1, BL2, ..., and BLm), and a source region of the ground select transistor GST may be connected to the common source line CSL. The common source line CSL may be a region where source regions of a plurality of ground select transistors GST are commonly connected to each other.

The string select transistor SST may be connected to a string select line SSL, and the ground select transistor GST may be connected to a ground select line GSL. The plurality of memory cell transistors MC1, MC2, ..., MCn-1, and MCn may be respectively connected to the plurality of word lines WL (WL1, WL2, ..., WLn-1, and WLn).

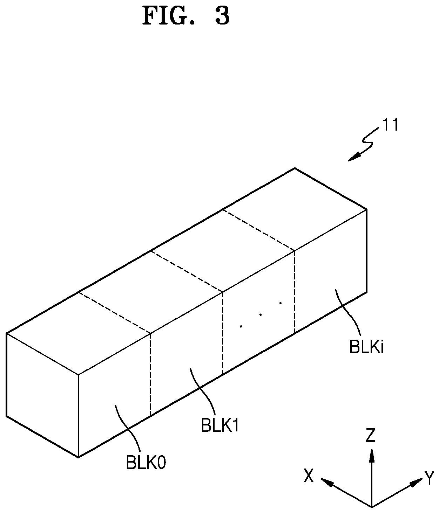

FIG. 3 illustrates an example of the memory cell array 11 according to one or more embodiments. Referring to FIG. 3, the memory cell array 11 may include a plurality of memory blocks BLKO to BLKi, wherein i may be a positive integer. Each of the plurality of memory blocks BLKO to BLKi may have a three-dimensional structure (or a vertical structure). Specifically, each of the plurality of memory blocks BLKO to BLKi may include a plurality of NAND strings stacked and extending in a vertical direction Z. At this time, the plurality of NAND strings may be provided to be spaced apart from each other by a certain distance in first and second directions X and Y. The plurality of memory blocks BLKO to BLKi may be selected by the row decoder 13 (in FIG. 1). For example, the row decoder 13 may select a memory block corresponding to a block address among the plurality of memory blocks BLKO to BLKi.

In the present disclosure, the terms "memory block" and "memory cell block" may be interchangeably used.

FIG. 4 illustrates examples of pass transistor circuit blocks and a memory cell array, according to one or more embodiments.

Referring to FIG. 4, the memory cell array 11 may include the plurality of memory blocks BLKO to BLKi, wherein i may be a positive integer. The pass transistor circuit 12 may include a plurality of pass transistor circuit blocks 12_0 to 12_n, wherein n may be a positive integer. According to one or more embodiments, i may be an integer equal to n, or i may be an integer different from n. According to one or more embodiments, when i and n are the same integer, the pass transistor circuit blocks 12_0 to 12_n may respectively correspond 1: 1 to the memory blocks BLKO to BLKi.

Referring to FIG. 4, the lengths of the plurality of memory blocks BLKO to BLKi in the second direction may be referred to as a block height. According to one or more embodiments, the pass transistor circuit blocks 12_0 to 12_n may have a length in the second direction corresponding to the block height of the plurality of memory blocks BLKO to BLKi.

A plurality of semiconductor devices may be aligned and arranged in the first and second directions in the plurality of pass transistor circuit blocks 12_0 to 12_n. According to one or more embodiments, the first direction may be an X-axis direction, and the second direction may be a Y-axis direction. Hereinafter, specific structures of the plurality of semiconductor devices are described.

According to one or more embodiments, a pass transistor may receive a voltage from a word line voltage generation circuit and apply the voltage to each corresponding word line. According to one or more embodiments, such a pass transistor may be required for each block and for each word line. As the number of word lines increases, the number of pass transistors may also increase. Accordingly, there has been a demand to reduce the size of pass transistors because the proportion of pass transistors in the area of a chip is increasing. To address this, proposed is a pass transistor having a different shape to existing ones.

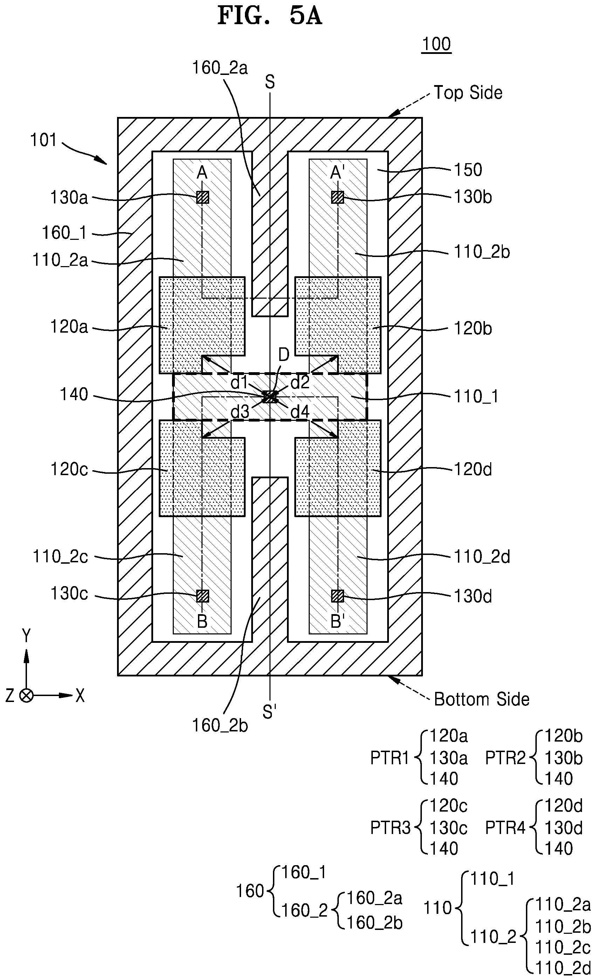

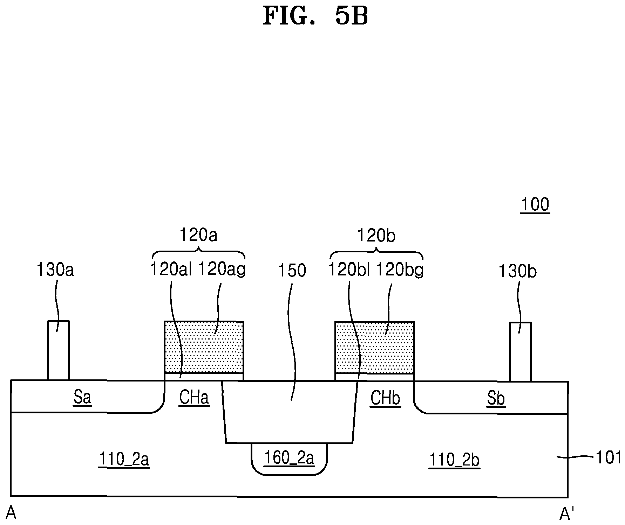

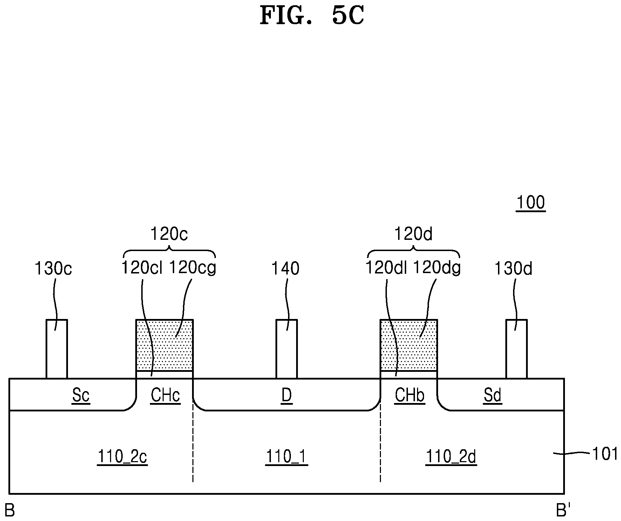

FIG. 5A is a layout diagram of a semiconductor device according to one or more embodiments. FIG. 5B is a cross-sectional view taken along a line A-A' of FIG. 5A. FIG. 5C is a cross-sectional view taken along a line B-B' of FIG. 5A.

Referring to FIGS. 5A, 5B, and 5C together, a semiconductor device 100 may include a substrate 101 and first to fourth gate structures 120a, 120b, 120c, and 120d. The semiconductor device 100 may be arranged in the pass transistor circuit blocks 12_0 to 12_n described with reference to FIG. 4.

The substrate 101 may include a semiconductor substrate. For example, the substrate 101 may include Si, Ge, or SiGe. An active region 110 may be defined in the substrate 101 by a device isolation film 150. First, second, third, and fourth pass transistors PTR1, PTR2, PTR3, and PTR4 may be formed on the active region 110.

The active region 110 may include a central active region 110_1 and first, second, third, and fourth separate active regions 110_2a, 110_2b, 110_2c, and 110_2d. In one or more embodiments, the central active region 110_1 and the first, second, third, and fourth separate active regions 110_2a, 110_2b, 110_2c, and 110_2d (i.e., the active region 110) may collectively form an H shape on an X-Y plane. Although the active region 110 is described as including several sub-regions, such as the central active region 110_1 and the first, second, third, and fourth separate active regions 110_2a, 110_2b, 110_2c, and 110_2d, these sub-regions may be interconnected to create a unified integrated active region, denoted as the active region 110.

The central active region 110_1 may extend in the first direction (e.g. the X-axis direction). The central active region 110_1 may have a rectangular shape on the X-Y plane.

A drain region D may be located above the central active region 110_1. The drain region D may be a region doped with first impurities. The first impurities may be, for example, n-type impurities such as phosphorus (P). The drain region D may be connected to a drain contact 140. The drain contact 140 may receive an operating voltage from a voltage generation circuit included in the peripheral circuit PECT (see FIG. 1), and may apply the operating voltage to the word line WL (see FIG. 1), string select line SSL (see FIG. 1), and ground select line GSL of the selected memory cell block. The operating voltage may be, for example, a program voltage V_{pgm}. In one or more embodiments, the drain contact 140 may be arranged on the X-Y plane in a diagonal direction with respect to the first to fourth gate structures 120a, 120b, 120c, and 120d. In one or more embodiments, separation distances d1, d2, d3, and d4 between the drain contact 140 and respective first to fourth gate structures 120a, 120b, 120c, and 120d may be equal to each other. Because the drain contact 140 is positioned diagonally relative to the first to fourth gate structures 120a, 120b, 120c, and 120d, the separation distances between the drain contact 140 and the first to fourth gate structures 120a, 120b, 120c, and 120d are maintained, while the area occupied by the first to fourth pass transistors PTR1, PTR2, PTR3, and PTR4 may be reduced. This arrangement may prevent breakdown of first to fourth gate dielectric films 120al, 120bl, 120cl, and 120dl due to an electric field that could occur with reduced separation distances between the drain contact 140 and the first to fourth gate structures 120a, 120b, 120c, and 120d, while enabling a reduction in the area of the first to fourth pass transistors PTR1, PTR2, PTR3, and PTR4.

It should be noted that the drain region D shown in the central active region 110_1 may be a source/drain region according to one or more embodiments. In the present disclosure, the term "source/drain region" may mean either one or both of a source region and a drain region.

The first, second, third, and fourth separate active regions 110_2a, 110_2b, 110_2c, and 110_2d may extend from the central active region 110_1 in the second direction (e.g. the Y-axis direction) perpendicular to the first direction. Specifically, the first separate active region 1 10_2a may extend in the second direction from one edge of the central active region 110_1 to a top side of a surface of the substrate 101, the second separate active region 110_2b may extend in the second direction from another edge of the central active region 110_1 to the top side, the third separate active region 110_2c may extend in the second direction from the one edge of the central active region 110_1 to a bottom side of the surface of the substrate 101, and the fourth separate active region 110_2d may extend in the second direction from the other edge of the central active region 110_1 to the bottom side. The first, second, third, and fourth separate active regions 110_2a, 110_2b, 110_2c, and 110_2d may have a rectangular shape on the X-Y plane. The terms "top side" and "bottom side" of substrate 101 denote two opposing sides on the X-Y plane. Depending on the viewpoint of semiconductor device 100, these designations may interchange.

In one or more embodiments, the first separate active region 110_2a and the second separate active region 110_2b may be symmetrical to each other with respect to an imaginary line S-S' passing through a central portion of the central active region 110_1, and the third separate active region 110_2c and the fourth separate active region 110_2d may be symmetrical to each other with respect to the imaginary line S-S'.

First, second, third, and fourth source regions Sa, Sb, Sc, and Sd may be respectively located above the first, second, third, and fourth separate active regions 110_2a, 110_2b, 110_2c, and 110_2d. Particularly, the first source region Sa may be located above the first separate active region 110_2a, the second source region Sb may be located above the second separate active region 110_2b, the third source region Sc may be located above the third separate active region 110_2c, and the fourth source region Sd may be located above the fourth separate active region 110_2d in the z-direction. The first, second, third, and fourth separate active regions 110_2a, 110_2b, 110_2c, and 110_2d may be regions doped with second impurities. The second impurities may be, for example, n-type impurities such as phosphorous (P).

The first, second, third, and fourth source regions Sa, Sb, Sc, and Sd may be respectively connected to first, second, third, and fourth contacts 130a, 130b, 130c, and 130d. According to one or more embodiments, the first, second, third, and fourth contacts 130a, 130b, 130c, and 130d may be source contacts. The first, second, third, and fourth contacts 130a, 130b, 130c, and 130d may receive the operating voltage from the drain contact 140, and may apply the operating voltage to the word line WL (see FIG. 1), string select line SSL (see FIG. 1), and ground select line GSL of the selected memory cell block. For example, when a memory cell block (hereinafter, referred to as a first memory cell block) connected to the first contact 130a is selected, the first contact 130a may receive the operating voltage from the drain contact 140 and apply the operating voltage to a word line of the first memory cell block.

The first, second, third, and fourth gate structures 120a, 120b, 120c, and 120d may be arranged apart from each other on the substrate 101. Specifically, the first gate structure 120a may be disposed on the first separate active region 110_2a of the substrate 101, the second gate structure 120b may be disposed on the second separate active region 110_2b of the substrate 101, the third gate structure 120c may be disposed on the third separate active region 110_2c of the substrate 101, and the fourth gate structure 120d may be disposed on the fourth separate active region 110_2d of the substrate 101, wherein the first gate structure 120a, the second gate structure 120b, the third gate structure 120c, and the fourth gate structure 120d may be spaced apart from each other. The shared drain region D of the four pass transistors PTR1, PTR2, PTR3, and PTR4 may be positioned at a midpoint of four corners, while the four gate structures 120a, 120b, 120c, and 120d of the four pass transistors PTR1, PTR2, PTR3, and PTR4 are positioned at the four corners, forming a symmetrical arrangement.

First, second, third, and fourth channel regions CHa, CHb, CHc, and CHd may be respectively located above the first, second, third, and fourth separate active regions 110_2a, 110_2b, 110_2c, and 110_2d respectively overlapping the first, second, third, and fourth gate structures 120a, 120b, 120c, and 120d in a third direction (e.g. the Z-axis direction) perpendicular to the first and second directions. For example, the first channel region CHa may be located above the first separate active region 110_2a overlapping the first gate structure 120a in the third direction.

The first gate structure 120a may form the first pass transistor PTR1 together with the first source region Sa and the drain region D. The second gate structure 120b may form the second pass transistor PTR2 together with the second source region Sb and the drain region D. The third gate structure 120c may form the third pass transistor PTR3 together with the third source region Sc and the drain region D. The fourth gate structure 120d may form the fourth pass transistor PTR4 together with the fourth source region Sd and the drain region D. In other words, as described above, the first, second, third, and fourth pass transistors PTR1, PTR2, PTR3, and PTR4 may share one drain region D.

The first, second, third, and fourth pass transistors PTR1, PTR2, PTR3, and PTR4 may be configured to apply an operating voltage to different memory cell blocks. For example, one of the first, second, third, and fourth pass transistors PTR1, PTR2, PTR3, and PTR4 may be configured to apply an operating voltage to one of different memory cell blocks, based on a memory cell block select signal.

In one or more embodiments, the first, second, third, and fourth pass transistors PTR1, PTR2, PTR3, and PTR4 may be high-voltage pass transistors capable of applying a high voltage to the memory cell block. The high voltage may be, for example, about 10 V to about 30 V.

The first, second, third, and fourth gate structures 120a, 120b, 120c, and 120d may respectively include the first, second, third, and fourth gate dielectric films 120al, 120bl, 120cl, and 120dl, and first, second, third, and fourth gate electrodes 120ag, 120bg, 120cg, and 120dg respectively disposed on the first, second, third, and fourth gate dielectric films 120al, 120bl, 120cl, and 120dl. Each of the first, second, third, and fourth gate dielectric films 120al, 120bl, 120cl, and 120dl may include, for example, a silicon oxide film, a silicon nitride film, a silicon oxynitride film, or a combination thereof. Each of the first, second, third, and fourth gate electrodes 120ag, 120bg, 120cg, and 120dg may include, for example, aluminum, silver, copper, molybdenum, chromium, tantalum, titanium, or a combination thereof.

In the substrate 101, an isolation region 160 may be located under the device isolation film 150. The isolation region 160 may be a region doped with third impurities. The third impurities may be, for example, p-type impurities such as boron (B). The isolation region 160 may electrically isolate the first, second, third, and fourth source regions Sa, Sb, Sc, and Sd from each other.

The isolation region 160 may include a first isolation region 160_1 surrounding the active region 110, and a first extension isolation region 160_2a and a second extension isolation region 160_2b, which extend from the first isolation region 160_1 toward the central active region 110_1 in the second direction. The first extension isolation region 160_2a and the second extension isolation region 160_2b may be symmetrical to each other with respect to the line S-S'. In one or more embodiments, the first extension isolation region 160_2a may extend in the second direction along a pathway between the first contact 130a and the second contact 130b, and the second extension isolation region 160_2b may extend in the second direction along a pathway between the third contact 130c and the fourth contact 130d. Accordingly, the first extension isolation region 160_2a may electrically isolate the first contact 130a and the second contact 130b from each other, and the second extension isolation region 160_2b may electrically isolate the third contact 130c and the fourth contact 130d from each other. In FIG. 5B, the first extension isolation region 160_2a is extended in the second direction so as to be located between the first gate structure 120a and the second gate structure 120b, and the second extension isolation region 160_2b is extended in the second direction so as to be located between the third gate structure 120c and the fourth gate structure 120d. However, as necessary, the first extension isolation region 160_2a and the second extension isolation region 160_2b may be further extended or shortened.

The semiconductor device 100 according to one or more embodiments includes the active region 110 having an H shape and the first to fourth gate structures 120a, 120b, 120c, and 120d disposed on the active region 110, wherein the active region 110 and respective first to fourth gate structures 120a, 120b, 120c, and 120d form respective first to fourth pass transistors PTR1, PTR2, PTR3, and PTR4, and share one drain region of the active region 110. Accordingly, the area of each pass transistor may be reduced compared to conventional semiconductor devices including an active region, two gate structures disposed above the active region, and two pass transistors sharing one drain region of the active region. In addition, compared to conventional semiconductor devices, in the semiconductor device 100 according to embodiments of the present disclosure, a separation distance between neighboring drain contacts 140 is relatively increased, allowing for better electrical isolation between the neighboring drain contacts 140. Therefore, the performance and reliability of the semiconductor device 100 according to one or more embodiments may be improved.

An active region of a semiconductor device including a pass transistor, according to embodiments of the present disclosure, may have an H shape. The central active region 110_1 may have a rectangular shape. The first and the second separate active regions 1 10_2a and 1 10_2b may extend in one direction from the central active region 110_1, to be parallel to each other. The third and the fourth separate active regions 110_2c and 110_2d may extend from the central active region 110_1 in the opposite direction, to be parallel to each other. A semiconductor device in embodiments of the present disclosure may include one common source/drain region, that is, a region connected to a global word line, and may include local source/drain regions respectively connected to four different blocks.

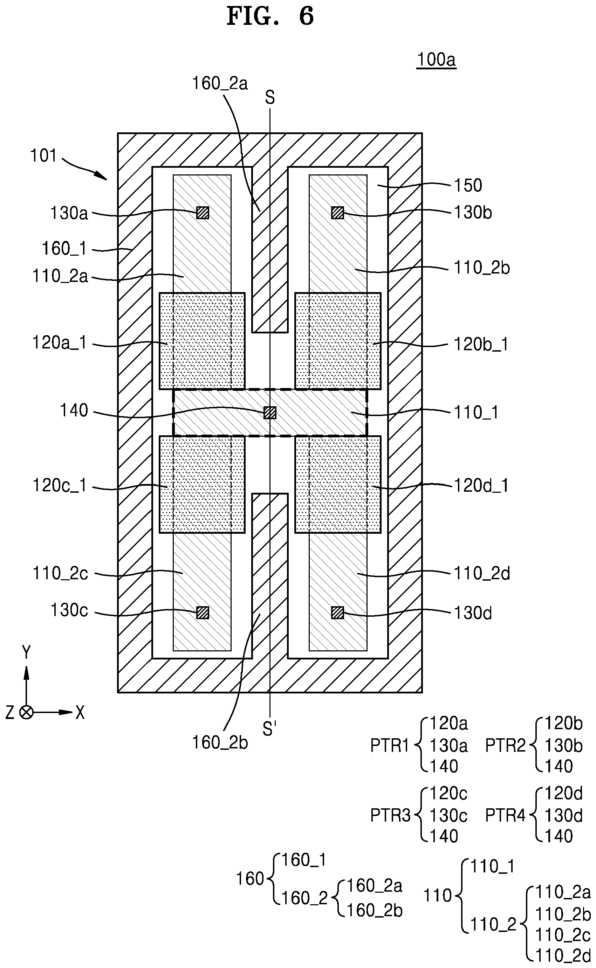

FIG. 6 is a layout diagram of a semiconductor device according to one or more embodiments. Each component of a semiconductor device 100a in FIG. 6 is the same as each component of the semiconductor device 100 described with reference to FIGS. 5A, 5B, and 5C, and thus, hereinafter, differences are mainly described.

The semiconductor device 100a in FIG. 6 may include the substrate 101, a first gate structure 120a_1, a second gate structure 120b_1, a third gate structure 120c_1, and a fourth gate structure 120d_1. According to one or more embodiments, each of the first gate structure 120a_1, the second gate structure 120b_1, the third gate structure 120c_1, and the fourth gate structure 120d_1 may be provided to have a rectangular shape.

According to one or more embodiments, the first gate structure 120a_1, the second gate structure 120b_1, the third gate structure 120c_1, and the fourth gate structure 120d_1 may be provided to have various shapes in addition to those shown in FIGS. 5A and 6.

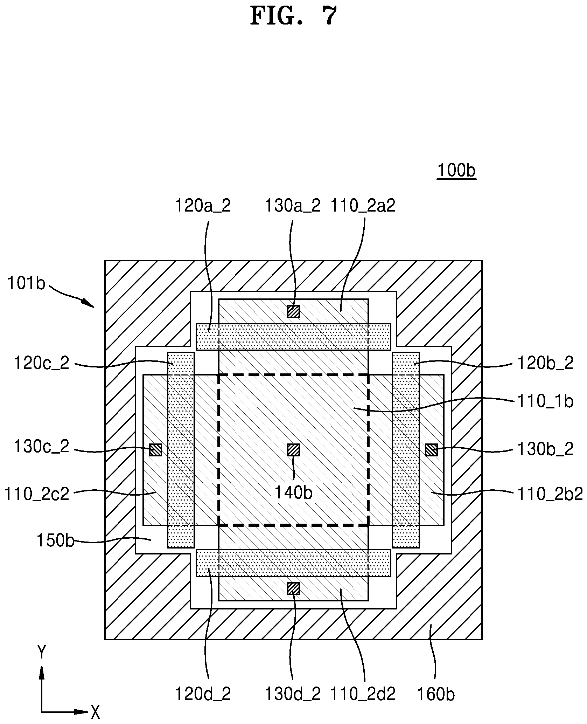

FIG. 7 is a layout diagram of a semiconductor device according to one or more embodiments. Each component of a semiconductor device 100b in FIG. 7 is the same as each component of the semiconductor device 100 described with reference to FIGS. 5A, 5B, and 5C, and thus, hereinafter, differences are mainly described.

The semiconductor device 100b in FIG. 7 may include a substrate 101b, a first gate structure 120a_2, a second gate structure 120b_2, a third gate structure 120c_2, and a fourth gate structure 120d_2. The semiconductor device 100b in FIG. 7 may include a central active region 110_1b, a first separate active region 110_2a2, a second separate active region 110_2b2, a third separate active region 110_2c2, and a fourth separate active region 110_2d2. Each of the first separate active region 110_2a2, the second separate active region 110_2b2, the third separate active region 110_2c2, and the fourth separate active region 110_2d2 may be arranged apart from the central active region 110_1b.

The central active region 110_1b may be connected to a drain contact 140b, the first separate active region 110_2a2 may be connected to a first contact 130a_2, the second separate active region 110_2b2 may be connected to a second contact 130b_2, the third separate active region 110_2c2 may be connected to a third contact 130c_2, and the fourth separate active region 110_2d2 may be connected to a fourth contact 130d_2. According to one or more embodiments, the first, second, third, and fourth contacts 130a_2, 130b_2, 130c_2, and 130d_2 may be source contacts.

According to one or more embodiments, an active region formed by the central active region 110_1b, the first separate active region 110_2a2, the second separate active region 110_2b2, the third separate active region 110_2c2, and the fourth separate active region 1 10_2d2 may be provided to have a cross shape. The central active region 110_1b may have a square or rectangular shape and may be positioned at a midpoint of four outer points. The first separate active region 110_2a2, the second separate active region 110_2b2, the third separate active region 110_2c2, and the fourth separate active region 110_2d2 may extend from the midpoint towards the four outer points, respectively, ensuring symmetry both vertically and horizontally in the cross shape of the active region.

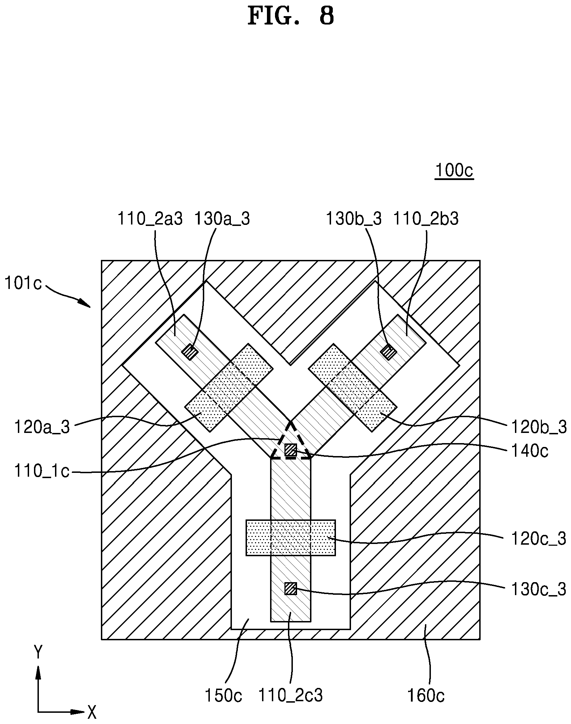

FIG. 8 is a layout diagram of a semiconductor device according to one or more embodiments. Each component of a semiconductor device 100c in FIG. 8 is the same as each component of the semiconductor device 100 described with reference to FIGS. 5A, 5B, and 5C, and thus, hereinafter, differences are mainly described.

The semiconductor device 100c in FIG. 8 may include a substrate 101c, a first gate structure 120a_3, a second gate structure 120b_3, and a third gate structure 120c_3. The semiconductor device 100c in FIG. 8 may include a central active region 110_1c, a first separate active region 110_2a3, a second separate active region 110_2b3, and a third separate active region 110_2c3. Each of the first separate active region 110_2a3, the second separate active region 110_2b3, and the third separate active region 110_2c3 may extend from the central active region 110_1c. According to one or more embodiments, three gate structures may are spaced apart from each other through the central active region 110_1c.

The central active region 110_1c may be connected to a drain contact 140c, the first separate active region 110_2a3 may be connected to a first contact 130a_3, the second separate active region 110_2b3 may be connected to a second contact 130b_3, and the third separate active region 110_2c3 may be connected to a third contact 130c_3. According to one or more embodiments, the first, second, third, and fourth contacts 130a_3, 130b_3, 130c_3, and 130d_3 may be source contacts.

According to one or more embodiments, an active region formed by the central active region 110_1c, the first separate active region 110_2a3, the second separate active region 110_2b3, and the third separate active region 110_2c3 may be provided to have a Y shape. The central active region 110_1c may have a triangle shape located at a midpoint of three corner points, and the first separate active region 110_2a3, the second separate active region 110_2b3, and the third separate active region 110_2c3 may extend from the midpoint towards the three corner points, respectively.

The shape of an active region and the shape of a gate structure, according to embodiments of the present disclosure, may not be limited to those shown in FIGS. 5A to 8, and it should be noted that various modifications may be provided within the scope of achieving the objectives according to embodiments of the present disclosure. Hereinafter, for convenience of explanation, an arrangement structure and wiring structure of semiconductor devices are described based on semiconductor devices having an H-shaped active region. However, the following arrangement structure and wiring structure are not limited to the semiconductor devices having an H-shaped active region, but may also be applied to semiconductor devices having other shapes of active regions.

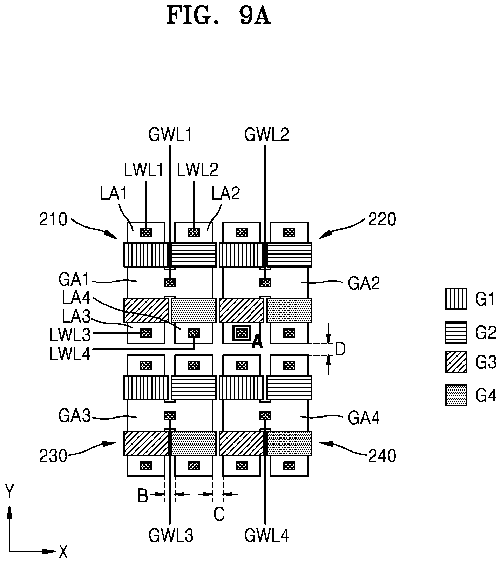

FIG. 9A is a diagram describing an arrangement structure of semiconductor devices according to one or more embodiments.

Referring to FIG. 9A, four semiconductor devices 210, 220, 230, and 240 having an H-shaped active region are arranged in the form of a 2X2 matrix. According to one or more embodiments, two of the semiconductor devices 210, 220, 230, and 240 are arranged in parallel with each other in the first direction (e.g. the X-axis direction), and the other two thereof are arranged in parallel with each other in the first direction. The structures and patterns of the semiconductor devices 210, 220, 230, and 240 are identical to each other, and thus, description is provided for only one semiconductor device 210.

Each of the semiconductor devices 210, 220, 230, and 240 may include first to four gate structures G1, G2, G3, and G4. The first gate structure G1 and the second gate structure G2 may be positioned adjacent to each other in the first direction, within one semiconductor device. The third gate structure G3 and the fourth gate structure G4 may be positioned adjacent to each other in the first direction, within one semiconductor device. The first gate structure G1 and the third gate structure G3 may be positioned adjacent to each other in the second direction (e.g. the Y-axis direction), within one semiconductor device.

Referring to FIG. 9A, the first gate structure G1, second gate structure G2, third gate structure G3, and fourth gate structure G4 of the semiconductor device 210 may share a common source/drain region GA1. The common source/drain region GA1 may correspond to the above-described central active region. Referring to FIG. 9A, the first gate structure G1 of the semiconductor device 210 may be adjacent to a first local source/drain region LA1. The second gate structure G2 of the semiconductor device 210 may be adjacent to a second local source/drain region LA2. The third gate structure G3 of the semiconductor device 210 may be adjacent to a third local source/drain region LA3. The fourth gate structure G4 of the semiconductor device 210 may be adjacent to a fourth local source/drain region LA4.

According to one or more embodiments, the common source/drain region GA1, the first local source/drain region LA1, and the first gate structure G1 may form a first pass transistor. The common source/drain region GA1, the second local source/drain region LA2, and the second gate structure G2 may form a second pass transistor. The common source/drain region GA1, the third local source/drain region LA3, and the third gate structure G3 may form a third pass transistor. The common source/drain region GA1, the fourth local source/drain region LA4, and the fourth gate structure G4 may form a fourth pass transistor.

Referring to FIG. 9A, a contact connected to the common source/drain region GA1 of the semiconductor device 210 may be connected to a first global word line GWL1. A contact connected to the first local source/drain region LA1 of the semiconductor device 210 may be connected to a first local word line LWL 1. A contact connected to the second local source/drain region LA2 of the semiconductor device 210 may be connected to a second local word line LWL2. A contact connected to the third local source/drain region LA3 of the semiconductor device 210 may be connected to a third local word line LWL3. A contact connected to the fourth local source/drain region LA4 of the semiconductor device 210 may be connected to a fourth local word line LWL4. According to one or more embodiments, the first pass transistor included in the semiconductor device 210 may be connected to the first local word line LWL1. The second pass transistor included in the semiconductor device 210 may be connected to the second local word line LWL2. The third pass transistor included in the semiconductor device 210 may be connected to the third local word line LWL3. The fourth pass transistor included in the semiconductor device 210 may be connected to the fourth local word line LWL4.

According to one or more embodiments, the common source/drain region GA1 included in the semiconductor device 210 may be connected to the first global word line GWL1, and the first local source/drain region LA1 to the fourth local source/drain region LA4 included in the semiconductor device 210 may be connected to local word lines of different blocks. According to one or more embodiments, there may be memory cell blocks respectively connected to the first local source/drain region LA1 to the fourth local source/drain region LA4, and an operating voltage may be applied to a word line of a corresponding memory cell block. According to one or more embodiments, the first local source/drain region LA1, the second local source/drain region LA2, the third local source/drain region LA3 and the fourth local source/drain region LA4 included in the semiconductor device 210 may be respectively connected to local word lines of different blocks.

Referring to FIG. 9A, the first global word line GWL1 may be connected to the common source/drain region GA1 of the semiconductor device 210, a second global word line GWL2 may be connected to a common source/drain region GA2 of the semiconductor device 220, a third global word line GWL3 may be connected to a common source/drain region GA3 of the semiconductor device 230, and a fourth global word line GWL4 may be connected to a common source/drain region GA4 of the semiconductor device 240.

In other words, the common source/drain regions GA1, GA2, GA3, and GA4 of respective semiconductor devices 210, 220, 230, and 240 may be respectively connected to different global word lines. Wirings may be connected in the second direction or the first direction, between local word lines corresponding to each other in the local source/drain regions of each of the semiconductor devices 210, 220, 230, and 240.

According to one or more embodiments, when the third gate structure G3 adjacent to a region A in FIG. 9A is turned on, a local word line connected to the region A may be selected, and all word lines connected to local source/drain regions adjacent to the region A may all be local word lines of different blocks. Accordingly, the local source/drain regions adjacent to the region A may be subjected to floating treatment. Therefore, consistent voltage conditions for the surrounding local source/drain regions may be established.

Referring to FIG. 9A, a gap in the first direction between separate active regions within each semiconductor devices may be B. According to one or more embodiments, B may be an active space. Referring to FIG. 9A, a gap in the first direction between separate active regions of respective semiconductor devices may be C. Referring to FIG. 9A, a gap in the second direction between separate active regions of respective semiconductor devices may be D. According to one or more embodiments, B, C, and D may be positive numbers greater than 0. According to one or more embodiments, B, C, and D may be equal to each other. In other words, a plurality of semiconductor devices may be arranged such that B, C, and D satisfy the same condition.

According to one or more embodiments of FIG. 9A, the arrangements of the first gate structure, second gate structure, third gate structure, and fourth gate structure in the semiconductor devices 210, 220, 230, and 240 may be identical to each other, and through such a structure, consistent voltage conditions for a local source/drain region environment around a selected local source/drain region may be established.

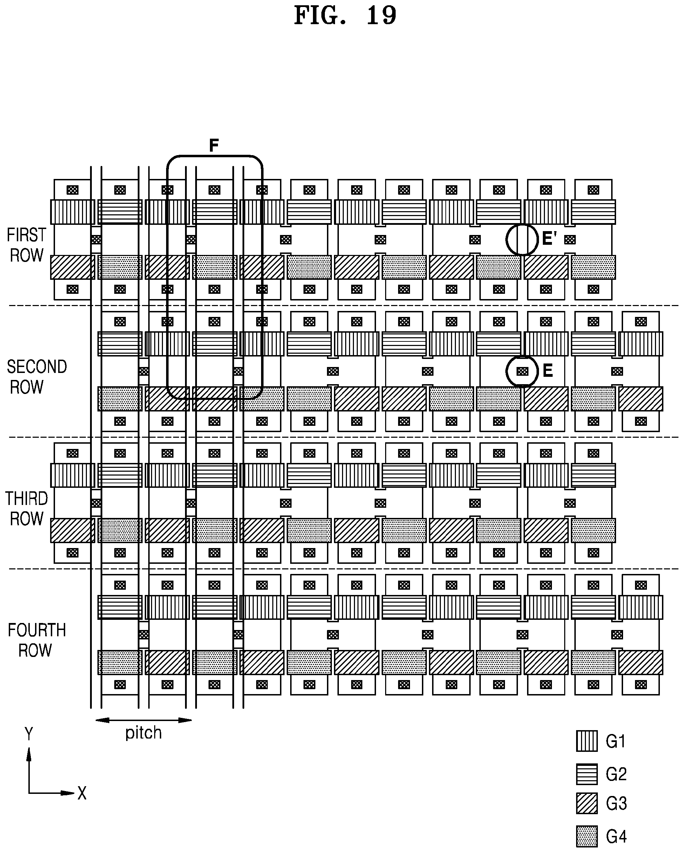

According to one or more embodiments, it should be noted that, in an arrangement structure of a plurality of semiconductor devices described below, the wiring structure between the semiconductor devices described with reference to FIG. 9A may be similarly applied. The wiring structure between a plurality of semiconductor devices is described in more detail with reference to FIGS. 19 to 23.

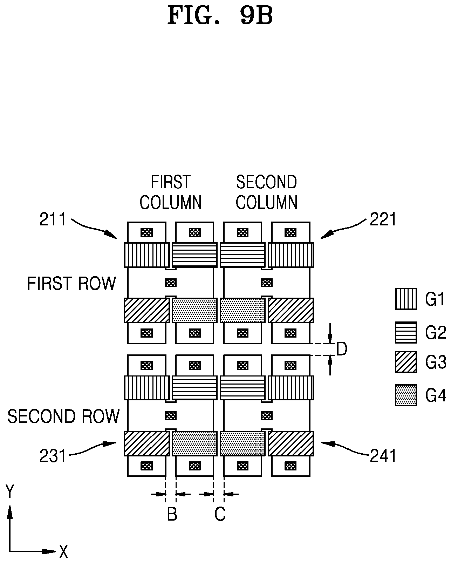

FIG. 9B is a diagram describing an arrangement structure of semiconductor devices according to one or more embodiments.

In the embodiment of FIG. 9B, descriptions already given with reference to FIG. 9A may omitted. Referring to FIG. 9B, first to fourth semiconductor devices 211, 221, 231, and 241 are shown. Each of the first to fourth semiconductor devices 211, 221, 231, and 241 may include the first gate structure G1, the second gate structure G2, the third gate structure G3, and the fourth gate structure G4.

The first semiconductor device 211 and the second semiconductor device 221 may be arranged adjacent to each other in the first direction (e.g. the X-axis direction). The first semiconductor device 211 and the third semiconductor device 231 may be arranged adjacent to each other in the second direction (e.g. the Y-axis direction).

The gate structures disposed above central portions of the first semiconductor device 211 and the second semiconductor device 221 may be arranged symmetrically about a Y axis between the first semiconductor device 211 and the second semiconductor device 221. Referring to FIG. 9B, the gate structures disposed above the central portion of the first semiconductor device 211 may be arranged in the order of the first gate structure G1 and the second gate structure G2, and the gate structures disposed above the central portion of the second semiconductor device 221 may be arranged in the order of the second gate structure G2 and the first gate structure G1.

The gate structures arranged below the central portions of the first semiconductor device 211 and the second semiconductor device 221 may be arranged symmetrically about the Y axis between the first semiconductor device 211 and the second semiconductor device 221. Referring to FIG. 9B, the gate structures disposed below the central portion of the first semiconductor device 211 may be arranged in the order of the third gate structure G3 and the fourth gate structure G4, and the gate structures disposed below the central portion of the second semiconductor device 221 may be arranged in the order of the fourth gate structure G4 and the third gate structure G3.

The third semiconductor device 231 and the fourth semiconductor device 241, which are located in a second row, may also be arranged in the same structure as the first semiconductor device 211 and the second semiconductor device 221.

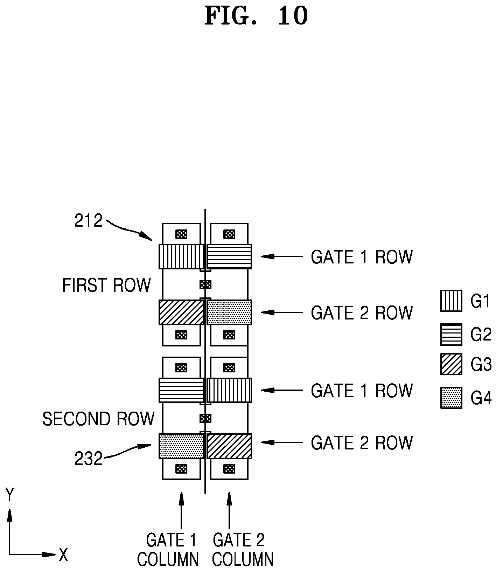

FIG. 10 is a diagram describing an arrangement structure of semiconductor devices according to one or more embodiments. In the embodiment of FIG. 10, descriptions already given with reference to FIG. 9A may omitted.

Referring to FIG. 10, first and second semiconductor devices 212 and 232 arranged adjacent to each other in the second direction (e.g. the Y-axis direction) are shown. The gate structures disposed above central portions of the first semiconductor device 212 and the second semiconductor device 232 may be arranged in a left-right symmetric manner between the first semiconductor device 212 and the second semiconductor device 232. Referring to FIG. 10, the gate structures disposed above the central portion of the first semiconductor device 212 may be arranged in the order of the first gate structure G1 and the second gate structure G2, and the gate structures disposed above the central portion of the second semiconductor device 232 may be arranged in the order of the second gate structure G2 and the first gate structure G1.

The gate structures disposed below the central portions of the first semiconductor device 212 and the second semiconductor device 232 may be arranged in a left-right symmetric manner between the first semiconductor device 212 and the second semiconductor device 232. Referring to FIG. 10, the gate structures disposed below the central portion of the first semiconductor device 212 may be arranged in the order of the third gate structure G3 and the fourth gate structure G4, and the gate structures disposed below the central portion of the second semiconductor device 232 may be arranged in the order of the fourth gate structure G4 and the third gate structure G3.

In other words, referring to FIG. 10, a gate 1 row of each of the semiconductor devices 212 and 232 may be left-right symmetrical to each other, and a gate 2 row of each of the semiconductor devices 212 and 232 may be left-right symmetrical to each other.

In embodiments of the present disclosure, a method for connecting word lines of semiconductor devices proposed herein without adding separate metal, that is, without increasing process costs, and an arrangement method therefore are disclosed. In embodiments, semiconductor devices having the same shape may be repeatedly arranged in the first direction, and gate structures having various symmetrical shapes may be repeatedly arranged in the second direction. In addition, the semiconductor devices may each require at least one metal in a bit-line direction for the purpose of connection with the same word line, and may share a track for the purpose of connecting word lines between semiconductor devices arranged in the same column. According to the embodiments, by arranging a plurality of semiconductor devices in a certain pattern in units of four blocks, the use of metal may be minimized in connecting word lines, and similar metal patterns may be formed for each small group.

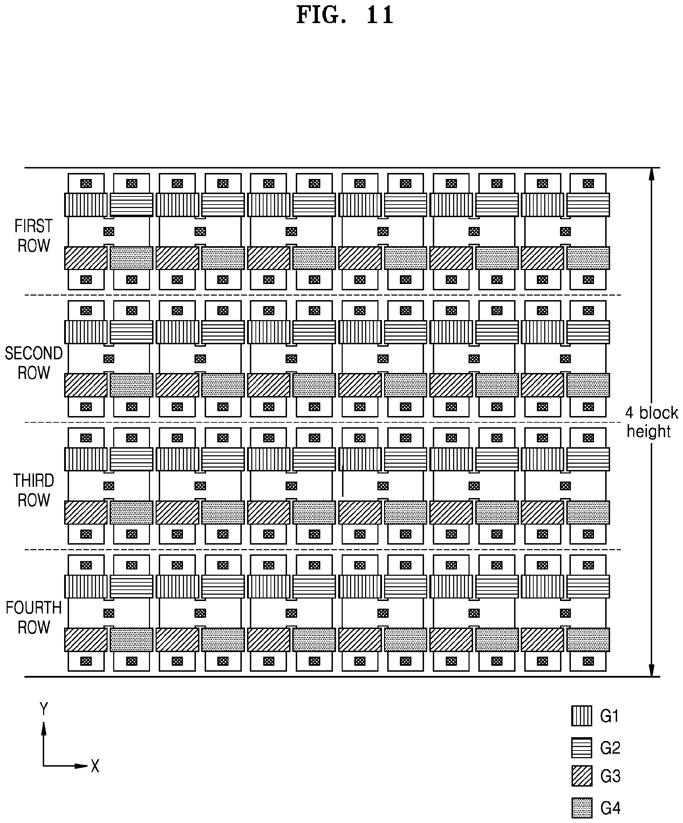

FIG. 11 is a diagram describing an example in which semiconductor devices are arranged to correspond to a plurality of block structures, according to one or more embodiments.

Referring to FIG. 11, a structure, in which a plurality of semiconductor devices are arranged in parallel with each other in the first direction (e.g. the X-axis direction) and the second direction (e.g. the Y-axis direction) to correspond to a four-block height, is shown. The height of each semiconductor device may correspond to the height of one memory block.

Referring to FIG. 11, six semiconductor devices are arranged in the first direction in each row, and four semiconductor devices are arranged in the second direction in each column. According to one or more embodiments, a plurality of semiconductor devices arranged in a first row may correspond to the first pass transistor circuit block in FIG. 4. A plurality of semiconductor devices arranged in a second row may correspond to the second pass transistor circuit block in FIG. 4. A plurality of semiconductor devices arranged in a third row may correspond to the third pass transistor circuit block in FIG. 4. A plurality of semiconductor devices arranged in a fourth row may correspond to the fourth pass transistor circuit block in FIG. 4. In the following embodiments, it may be understood that a plurality of semiconductor devices arranged in one row are included in one pass transistor circuit block.

According to one or more embodiments, arrangement structures of gate structures within a plurality of semiconductor devices may all be provided in the same pattern. This may be the same as the arrangement structure of the semiconductor devices in FIG. 9A.

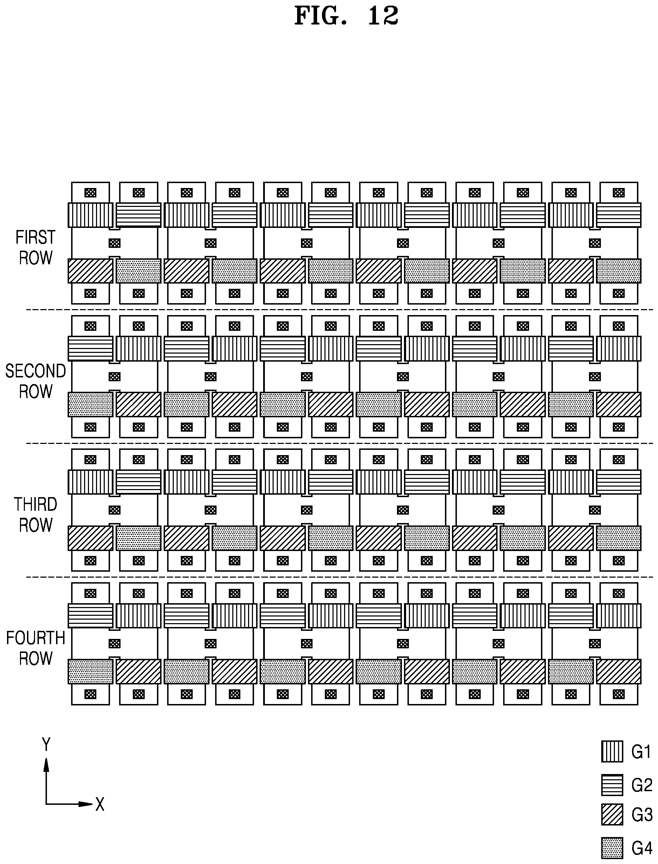

FIG. 12 is a diagram describing an example in which semiconductor devices are arranged to correspond to a plurality of block structures, according to one or more embodiments.

Referring to FIG. 12, a structure, in which a plurality of semiconductor devices are arranged in parallel with each other in the first direction (e.g. the X-axis direction) and the second direction (e.g. the Y-axis direction) to correspond to a four-block height, is shown. The plurality of semiconductor devices may be arranged in parallel with each other along a first row, a second row, a third row, and a fourth row in the first direction. According to one or more embodiments, patterns of a plurality of semiconductor devices arranged in the first row may be identical to patterns of a plurality of semiconductor devices arranged in the third row. Patterns of a plurality of semiconductor devices arranged in the second row may be identical to patterns of a plurality of semiconductor devices arranged in the fourth row.

According to one or more embodiments, the gate structures disposed above central portions of the plurality of semiconductor devices arranged in the first row may be left-right symmetrical to the gate structures disposed above central portions of the plurality of semiconductor devices arranged in the second row. According to one or more embodiments, the gate structures disposed below central portions of the plurality of semiconductor devices arranged in the first row may be left-right symmetrical to the gate structures disposed below central portions of the plurality of semiconductor devices arranged in the second row. This may be the same as the arrangement structure of the semiconductor devices shown in FIG. 10. In such a structure, a connection relationship between gates in adjacent rows may be Y-axis symmetrical to each other with respect to a central portion of a semiconductor device.

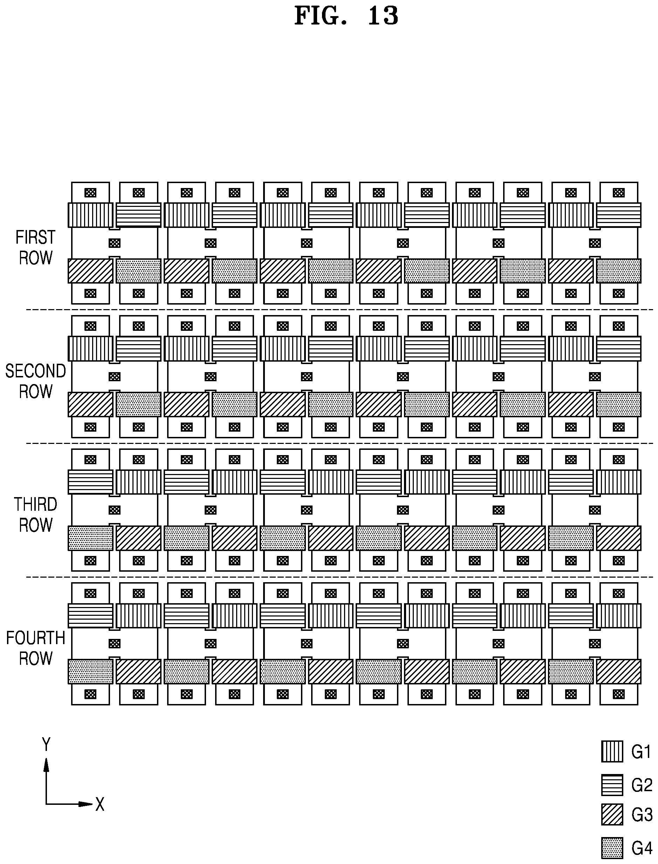

FIG. 13 is a diagram describing an example in which semiconductor devices are arranged to correspond to a plurality of block structures, according to one or more embodiments.

Referring to FIG. 13, a structure, in which a plurality of semiconductor devices are arranged in parallel with each other in the first direction (e.g. the X-axis direction) and the second direction (e.g. the Y-axis direction) to correspond to a four-block height, is shown. The plurality of semiconductor devices may be arranged in parallel with each other along a first row, a second row, a third row, and a fourth row in the first direction. According to one or more embodiments, patterns of a plurality of semiconductor devices arranged in the first row may be identical to patterns of a plurality of semiconductor devices arranged in the second row. Patterns of a plurality of semiconductor devices arranged in the third row may be identical to patterns of a plurality of semiconductor devices arranged in the fourth row.

According to one or more embodiments, the gate structures disposed above central portions of the plurality of semiconductor devices arranged in the second row may be left-right symmetrical to the gate structures disposed above central portions of the plurality of semiconductor devices arranged in the third row. According to one or more embodiments, the gate structures disposed below the central portions of the plurality of semiconductor devices arranged in the second row may be left-right symmetrical to the gate structures disposed below the central portions of the plurality of semiconductor devices arranged in the third row. This may be the same as the arrangement structure of the semiconductor devices shown in FIG. 10.

A configuration in which gates in specific rows are Y-axis symmetrical to each other within a column structure, as shown in FIG. 10, may be provided by dividing half of the total n rows as shown in FIGS. 12 and 13, or an asymmetrical arrangement configuration, such as 1:n-1 or 2:n-2 may be possible.

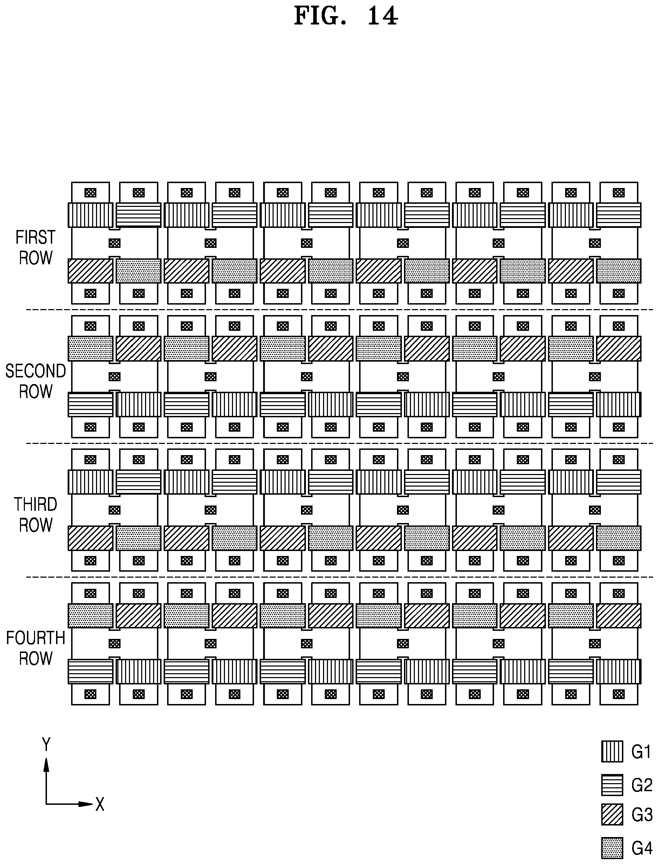

FIG. 14 is a diagram describing an example in which semiconductor devices are arranged to correspond to a plurality of block structures, according to one or more embodiments.

Referring to FIG. 14, a structure, in which a plurality of semiconductor devices are arranged in parallel with each other in the first direction (e.g. the X-axis direction) and the second direction (e.g. the Y-axis direction) to correspond to a four-block height, is shown. The plurality of semiconductor devices may be arranged in parallel with each other along a first row, a second row, a third row, and a fourth row in the first direction. According to one or more embodiments, patterns of a plurality of semiconductor devices arranged in the first row may be identical to patterns of a plurality of semiconductor devices arranged in the third row. Patterns of a plurality of semiconductor devices arranged in the second row may be identical to patterns of a plurality of semiconductor devices arranged in the fourth row. In other words, semiconductor devices in the first row may have identical patterns to those in the third row, while semiconductor devices in the second row may have identical patterns to those in the fourth row but have different patterns from those in the first row and the third row.

Referring to FIG. 14, the patterns of the plurality of semiconductor devices arranged in the first row may be arranged to have origin symmetry with the patterns of the plurality of semiconductor devices arranged in the second row with respect to a middle portion. The middle portion may refer to a middle point between a plurality of local source/drain regions and between the first row and the second row. The origin symmetry may refer to being diagonally symmetrical with respect to a point of reference for symmetry.

Referring to FIG. 14, a result of origin symmetry for the first gate structure G1 and the second gate structure G2, which are disposed above central portions of the patterns of the plurality of semiconductor devices arranged in the first row, may correspond to the second gate structure G2 and the first gate structure G1, which are disposed below central portions of the patterns of the plurality of semiconductor devices arranged in the second row. A result of origin symmetry for the third gate structure G3 and the fourth gate structure G4, which are disposed below central portions of the patterns of the plurality of semiconductor devices arranged in the first row, may correspond to the fourth gate structure G4 and the third gate structure G3, which are disposed above central portions of the patterns of the plurality of semiconductor devices arranged in the second row.

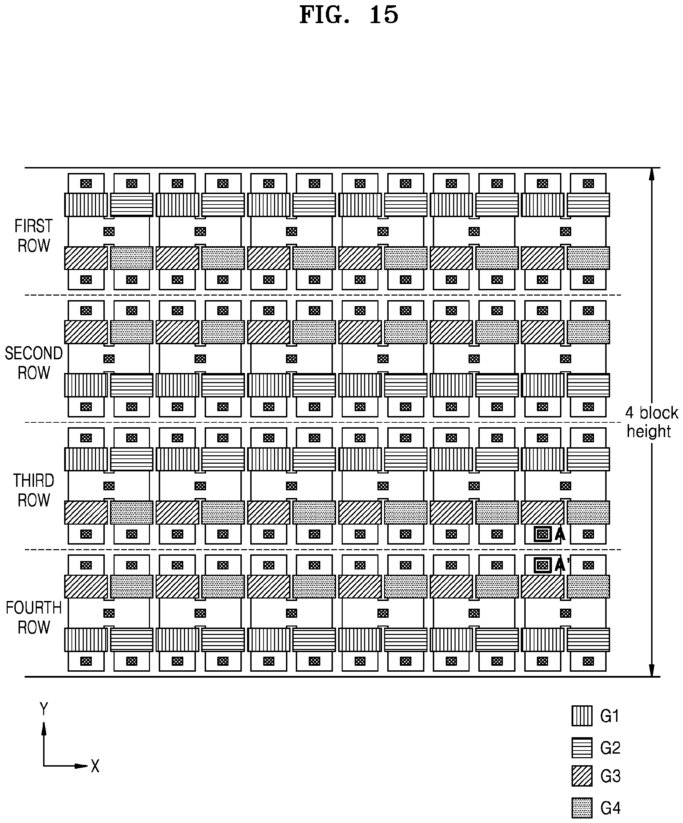

FIG. 15 is a diagram describing an example in which semiconductor devices are arranged to correspond to a plurality of block structures, according to one or more embodiments.

Referring to FIG. 15, a structure, in which a plurality of semiconductor devices are arranged in parallel with each other in the first direction (e.g. the X-axis direction) and the second direction (e.g. the Y-axis direction) to correspond to a four-block height, is shown. The plurality of semiconductor devices may be arranged in parallel with each other along a first row, a second row, a third row, and a fourth row in the first direction. According to the embodiment of FIG. 15, patterns of a plurality of semiconductor devices arranged in the first row may be identical to patterns of a plurality of semiconductor devices arranged in the third row. Patterns of a plurality of semiconductor devices arranged in the second row may be identical to patterns of a plurality of semiconductor devices arranged in the fourth row.

Referring to FIG. 15, the patterns of the plurality of semiconductor devices arranged in the first row may have mirror symmetry in the first direction with the patterns of the plurality of semiconductor devices arranged in the second row with respect to an imaginary line between the first row and the second row. A result of mirror symmetry in the first direction for the first gate structure G1 and the second gate structure G2, which are disposed above central points of the patterns of the plurality of semiconductor devices arranged in the first row, may correspond to the first gate structure G1 and the second gate structure G2, which are disposed below central points of the patterns of the plurality of semiconductor devices arranged in the second row. A result of mirror symmetry in the first direction for the third gate structure G3 and the fourth gate structure G4, which are disposed below central points of the patterns of the plurality of semiconductor devices arranged in the first row, may correspond to the third gate structure G3 and the fourth gate structure G4, which are disposed above central points of the patterns of the plurality of semiconductor devices arranged in the second row.

According to one or more embodiments, in such a structure, as shown in the region A and a region A', blocks in which local source/drain regions facing each other in the second direction of a specific local source/drain region are the same may face each other. In such a case, surrounding voltages of a selected local source/drain region may not all be subjected to floating.

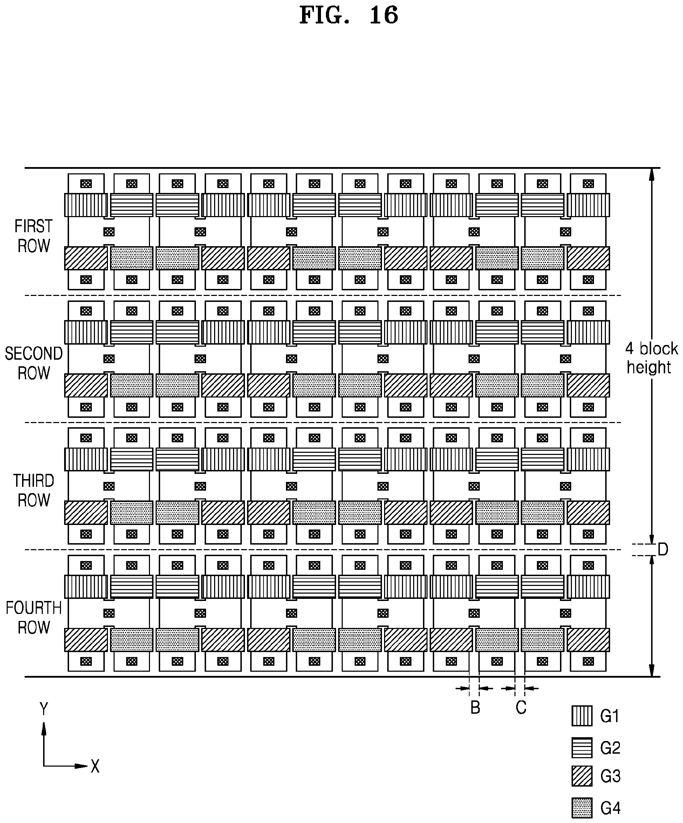

FIG. 16 is a diagram describing an example in which semiconductor devices are arranged to correspond to a plurality of block structures, according to one or more embodiments.

Referring to FIG. 16, a structure, in which a plurality of semiconductor devices are arranged in parallel with each other in the first direction (e.g. the X-axis direction) and the second direction (e.g. the Y-axis direction) to correspond to a four-block height, is shown. The plurality of semiconductor devices may be arranged in parallel with each other along a first row, a second row, a third row, and a fourth row in the first direction. Referring to FIG. 16, patterns of a plurality of semiconductor devices arranged in the first row, patterns of a plurality of semiconductor devices arranged in the second row, patterns of a plurality of semiconductor devices arranged in the third row, and patterns of a plurality of semiconductor devices arranged in the fourth row may be identical to each other.

Referring to FIG. 16, each of the plurality of semiconductor devices in the first row may be Y-axis symmetrical to adjacent semiconductor devices in the same row. According to one or more embodiments, such an arrangement structure may be the same as the arrangement structure of the semiconductor devices in FIG. 9B.

In such a configuration, a voltage of a block in which gate structures that are adjacent to each other in the first direction are the same may be applied, and at this time, gate nodes of gates in the same block may not be isolated. In this regard, the gate nodes may refer to gate contacts. In such a structure, corresponding local source/drain regions of gate structures that are adjacent to each other may be identical to each other, and thus, in such a structure, B may be greater than C (B>C).

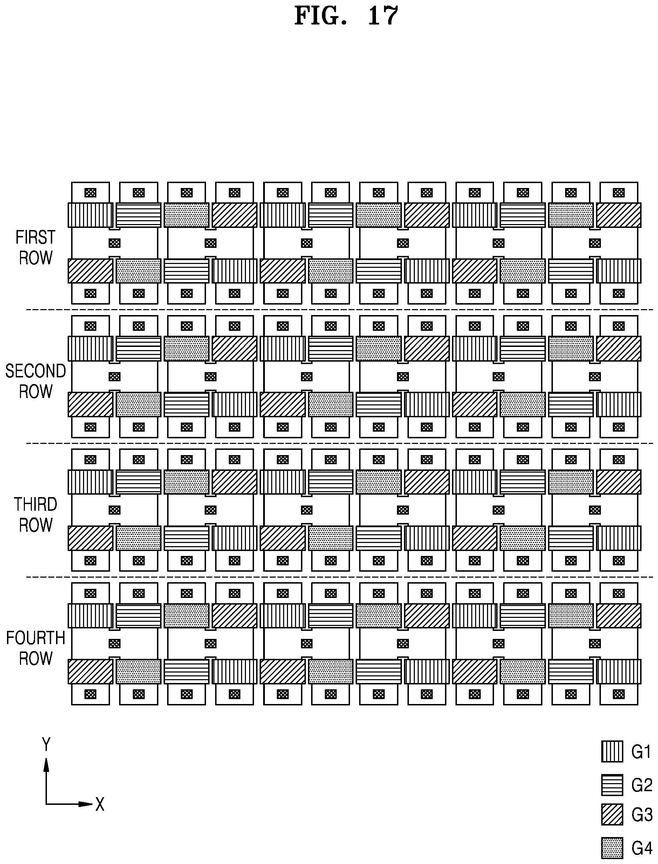

FIG. 17 is a diagram describing an example in which semiconductor devices are arranged to correspond to a plurality of block structures, according to one or more embodiments.

Referring to FIG. 17, a structure, in which a plurality of semiconductor devices are arranged in parallel with each other in the first direction (e.g. the X-axis direction) and the second direction (e.g. the Y-axis direction) to correspond to a four-block height, is shown. The plurality of semiconductor devices may be arranged in parallel with each other along a first row, a second row, a third row, and a fourth row in the first direction. Referring to FIG. 17, patterns of a plurality of semiconductor devices arranged in the first row, patterns of a plurality of semiconductor devices arranged in the second row, patterns of a plurality of semiconductor devices arranged in the third row, and patterns of a plurality of semiconductor devices arranged in the fourth row may be identical to each other.

Referring to FIG. 17, the patterns of the plurality of semiconductor devices in the first row may have origin symmetry in the second direction with adjacent semiconductor devices in the same row. A result of origin symmetry in the second direction for the first gate structure G1 and the second gate structure G2, which are disposed above central portions of the patterns of the plurality of semiconductor devices arranged in the first row, may correspond to the second gate structure G2 and the first gate structure G1, which are disposed below central portions of patterns of adjacent semiconductor devices in the first row. A result of origin symmetry in the second direction for the third gate structure G3 and the fourth gate structure G4, which are disposed below the central portions of the patterns of the plurality of semiconductor devices arranged in the first row, may correspond to the fourth gate structure G4 and the third gate structure G3, which are disposed above the central portions of the patterns of the adjacent semiconductor devices in the first row.

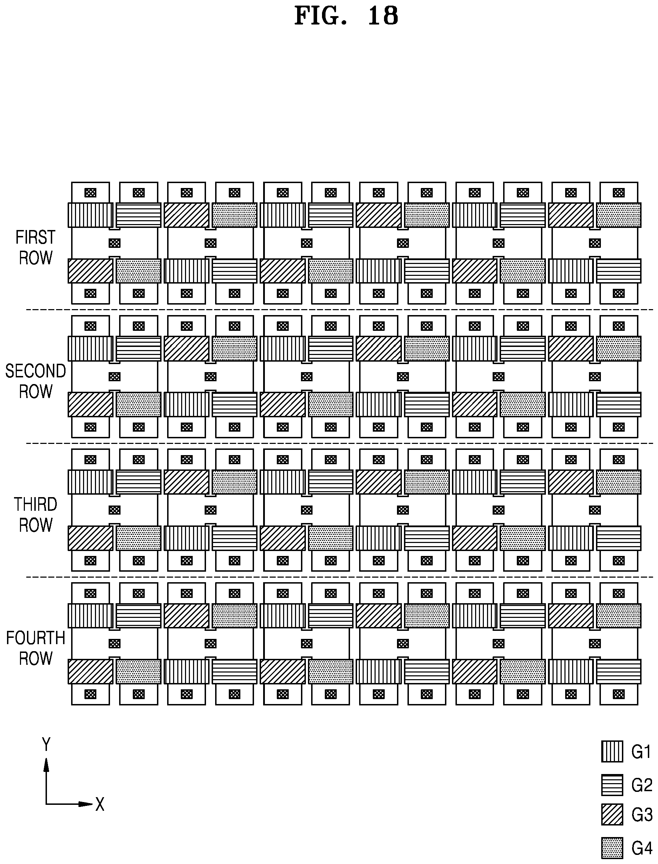

FIG. 18 is a diagram describing an example in which semiconductor devices are arranged to correspond to a plurality of block structures, according to one or more embodiments.

Referring to FIG. 18, a structure, in which a plurality of semiconductor devices are arranged in parallel with each other in the first direction (e.g. the X-axis direction) and the second direction (e.g. the Y-axis direction) to correspond to a four-block height, is shown. The plurality of semiconductor devices may be arranged in parallel with each other along a first row, a second row, a third row, and a fourth row in the first direction. Referring to FIG. 18, patterns of a plurality of semiconductor devices arranged in the first row, patterns of a plurality of semiconductor devices arranged in the second row, patterns of a plurality of semiconductor devices arranged in the third row, and patterns of a plurality of semiconductor devices arranged in the fourth row may be identical to each other.

Referring to FIG. 18, the patterns of the plurality of semiconductor devices in the first row may be X-axis symmetrical to patterns of adjacent semiconductor devices in the same row. Referring to FIG. 18, gate structures disposed above central portions of the patterns of the plurality of semiconductor devices in the first row may correspond to gate structures disposed below central portions of patterns of adjacent semiconductor devices in the same row. According to one or more embodiments, a result of X-axis symmetry for the first gate structure G1 and the second gate structure G2, which are disposed above the central portions of the plurality of semiconductor devices arranged in the first row, may correspond to the first gate structure G1 and the second gate structure G2, which are disposed below central portions of patterns of adj acent semiconductor devices in the first row. A result of X-axis symmetry for the third gate structure G3 and the fourth gate structure G4, which are disposed below the central portions of the patterns of the plurality of semiconductor devices arranged in the first row, may correspond to the third gate structure G3 and the fourth gate structure G4, which are disposed above the central portions of the patterns of the adjacent semiconductor devices in the first row.

According to the embodiments of FIGS. 16 to 18, a plurality of semiconductor devices may be provided in different patterns within the same row. In addition, in the embodiments of FIGS. 16 to 18, a plurality of semiconductor devices are provided in the same pattern in adjacent rows, but the embodiments are not limited thereto, and it should be noted that a plurality of semiconductor devices may be provided in different patterns in adjacent rows. In addition, in the embodiments of the drawings, patterns within the same row or patterns in adjacent rows are 1: 1 repeatedly formed, but it should be noted that an arrangement ratio of semiconductor patterns may be variously formed.

FIG. 19 is a diagram describing an example in which semiconductor devices are arranged to correspond to a plurality of block structures, according to one or more embodiments.

Referring to FIG. 19, a structure, in which a plurality of semiconductor devices are arranged in the first direction (e.g. the X-axis direction) and the second direction (e.g. the Y-axis direction)to correspond to a four-block height, is shown. The plurality of semiconductor devices may be arranged in parallel with each other along a first row, a second row, a third row, and a fourth row in the first direction. According to one or more embodiments, a plurality of semiconductor devices arranged in the first row and a plurality of semiconductor devices arranged in the second row may be offset from each other by half the pitch of a semiconductor device. The plurality of semiconductor devices arranged in the second row and a plurality of semiconductor devices arranged in the third row may be offset from each other by half the pitch of a semiconductor device. The plurality of semiconductor devices arranged in the third row and a plurality of semiconductor devices arranged in a fourth row may be offset from each other by half the pitch of a semiconductor device. Accordingly, the plurality of semiconductor devices may be arranged in a zigzag shape for each row.

Referring to FIG. 19, a region E is a node connected to a global word line of a semiconductor device, and a region E' is located at a point corresponding to a gap between semiconductor devices in adjacent columns. In other words, in such a case, a wiring of a global word line is provided in two units according to a point where a wiring of a global word line is misaligned, such as in a region F.

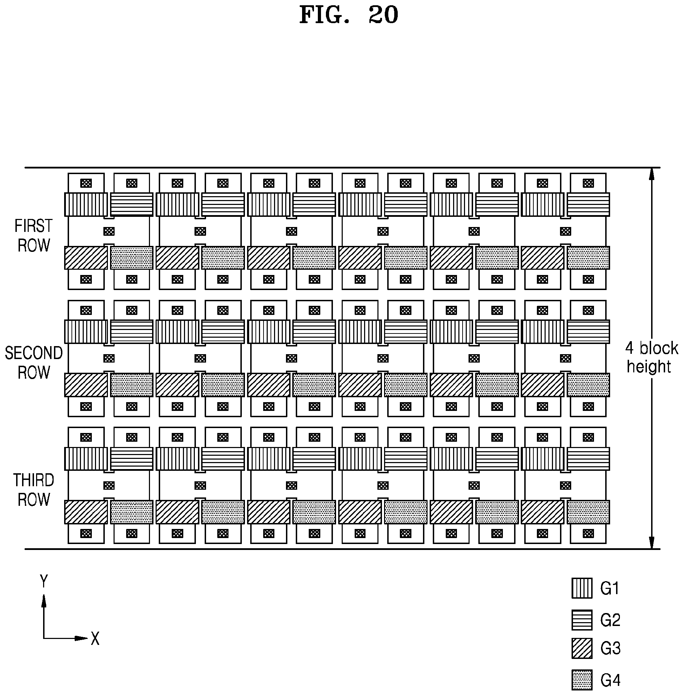

FIG. 20 is a diagram describing an example in which semiconductor devices are arranged to correspond to a plurality of block structures, according to one or more embodiments.

Referring to FIG. 20, a structure, in which a plurality of semiconductor devices are arranged in parallel with each other in the first direction (e.g. the X-axis direction) and the second direction (e.g. the Y-axis direction) to correspond to a four-block height, is shown. The plurality of semiconductor devices may be arranged in parallel with each other along a first row, a second row, and a third row in the first direction.

In the above-described embodiments, the descriptions have been provided based on a structure in which semiconductor devices are arranged in four tiers corresponding to the block heights of four memory blocks. However, such a structure may vary depending on the height of a block and the size of a semiconductor device in the vertical direction. Referring to FIG. 20, the heights of the plurality of semiconductor devices may not respectively correspond 1: 1 to the heights of memory blocks, and semiconductor devices may be provided in sizes larger than the heights of memory blocks, respectively. FIG. 20 shows an example in which three semiconductor devices corresponding to the heights of four memory blocks are arranged in parallel with each other in each column in the second direction, but the embodiments are not limited thereto, and n semiconductor devices corresponding to the heights of four memory blocks may be arranged in parallel with each other in each column in the second direction. In this regard, n may be a natural number of 1 or more.

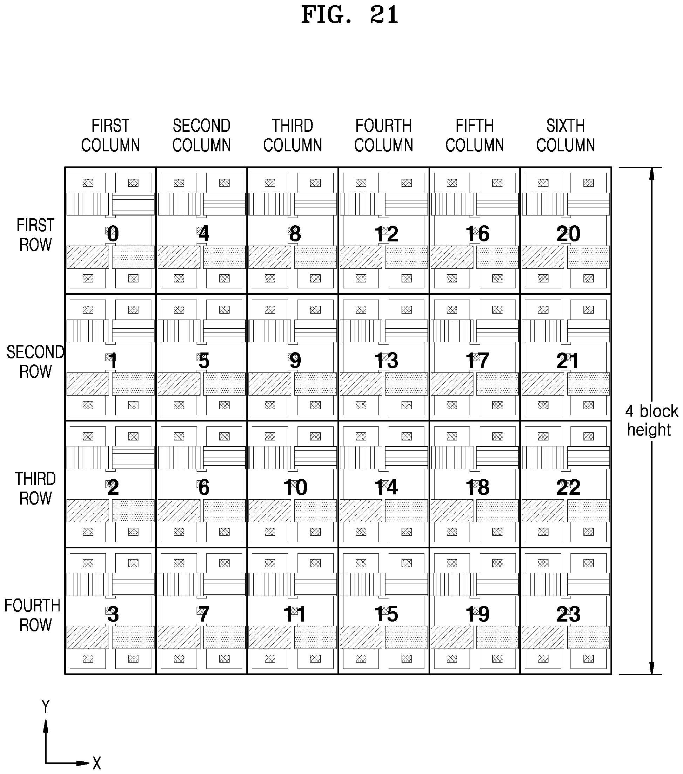

FIG. 21 is a diagram describing a connection structure between a semiconductor device and a word line, according to one or more embodiments.

Referring to FIG. 21, word lines that may be respectively connected to semiconductor devices are shown as examples. According to one or more embodiments, a word line connected to a semiconductor device arranged in a first column of a first row may have a word line number 0. According to one or more embodiments, a word line connected to a semiconductor device arranged in the first column of a second row may have a word line number 1. A word line connected to a semiconductor device arranged in the first column of a third row may have a word line number 2. A word line connected to a semiconductor device arranged in the first column of a fourth row may have a word line number 3. As such, word lines that may be respectively connected to semiconductor devices may each be determined.

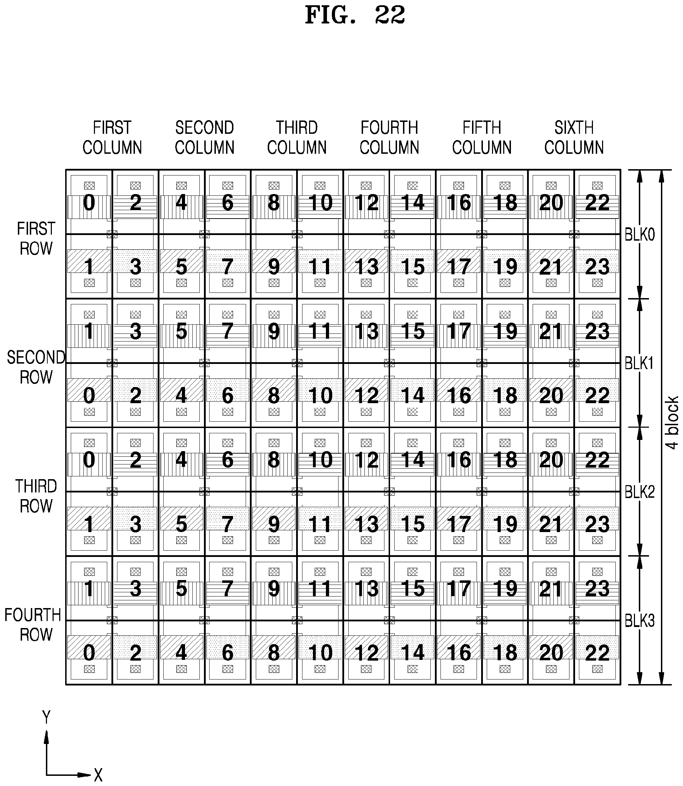

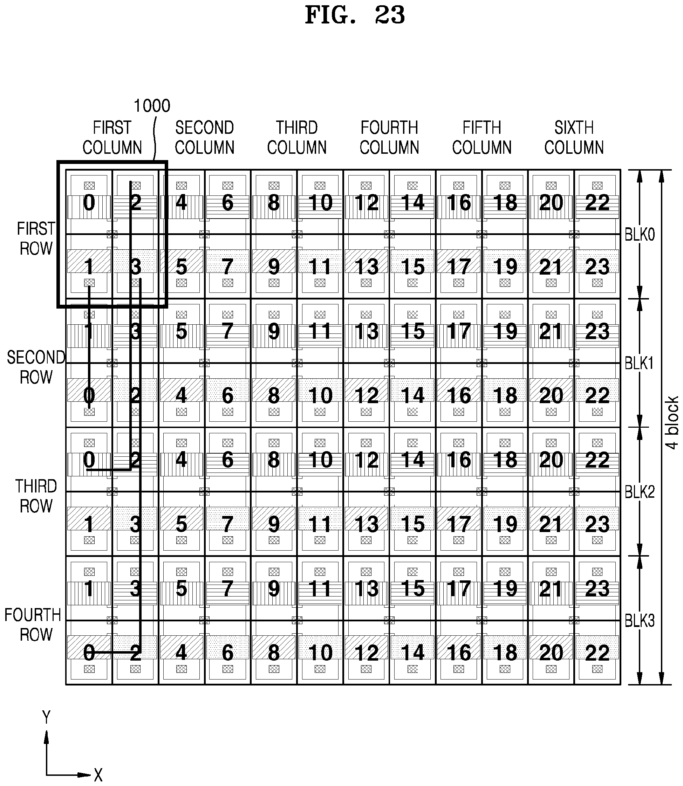

FIG. 22 is a diagram describing a connection structure between a semiconductor device and a word line, according to one or more embodiments. FIG. 23 is a diagram describing a connection structure between a semiconductor device and a local word line, according to one or more embodiments.

Referring to FIG. 22, the numbers for word lines respectively connected to semiconductor devices are shown, and each of the semiconductor devices may be connected to word line pads respectively corresponding to a plurality of gate structures. According to one or more embodiments, the number for a word line pad corresponding to a first gate structure of a semiconductor device arranged in a first column of a first row may be 0. The number for a word line pad corresponding to a second gate structure of the semiconductor device arranged in the first column of the first row may be 2. The number for a word line pad corresponding to a third gate structure of the semiconductor device arranged in the first column of the first row may be 1. The number for a word line pad corresponding to a fourth gate structure of the semiconductor device arranged in the first column of the first row may be 3.

According to one or more embodiments, the number for a word line pad corresponding to a first gate structure of a semiconductor device arranged in the first column of a second row may be 1. The number for a word line pad corresponding to a second gate structure of the semiconductor device arranged in the first column of the second row may be 3. The number for a word line pad corresponding to a third gate structure of the semiconductor device arranged in the first column of the second row may be 0. The number for a word line pad corresponding to a fourth gate structure of the semiconductor device arranged in the first column of the second row may be 2.

FIG. 23 is a diagram describing a wiring structure between different semiconductor devices based on a word line pad of FIG.22. According to one or more embodiments, word line pads respectively corresponding to a plurality of gate structures included in a plurality of semiconductor devices may be connected to word line pads located in different blocks.

According to one or more embodiments, a semiconductor device 1000 that should be connected to a word line number 0 located in a first memory block BLKO may be connected to other blocks having a word line pad number 0 of a plurality of other semiconductor devices arranged in the same column. Therefore, a semiconductor device that should be connected to the word line number 0 located in the first memory block BLK0 may be connected to the word line pad number 0 of the semiconductor device located in the first memory block BLK0, a word line pad number 0 of a semiconductor device located in a second memory block BLK1, a word line pad number 0 of a semiconductor device located in a third memory block BLK2, and a word line pad number 0 of a semiconductor device located in a fourth memory block BLK3. In other words, word line pads respectively corresponding to a plurality of gate structures included in a plurality of semiconductor devices may each be connected to a word line in another block, the number for which is identical to the number for the corresponding word line pad.

For example, local source/drain regions of each semiconductor device may be respectively connected to the word line pad number 0, a word line pad number 1, a word line pad number 2, and a word line pad number 3, in the semiconductor device that should be connected to the word line number 0. In this regard, in the case of a local source/drain region corresponding to the word line pad number 0, the number for the word line pad and the number for the word line of the corresponding semiconductor device are the same, and thus, connection with another block may not be necessary. A local source/drain region corresponding to the word line pad number 1 may be connected to a word line pad number 0 located in a block number 1. A local source/drain region corresponding to the word line pad number 2 may be connected to a word line pad 0 located in a block number 2. A local source/drain region corresponding to the word line pad number 3 may be connected to a word line pad number 0 located in a block number 3.

Referring to FIGS. 22 and 23, local source/drain regions corresponding to a plurality of gate structures included in each semiconductor device may respectively correspond to different memory cell blocks, and referring to the number for a word line pad corresponding local source/drain regions, a vertical wiring and horizontal wiring of local word lines between different blocks within the same column may be connected to each other. According to one or more embodiments, active regions of nodes of local word lines of four blocks are shared based on a node of a global word line, thereby enabling connection with the same word line of different four blocks. According to one or more embodiments, one wiring of four local source/drain regions may be connected to the same block where the corresponding semiconductor device is placed, and the remaining three wirings may be connected to the other three blocks.

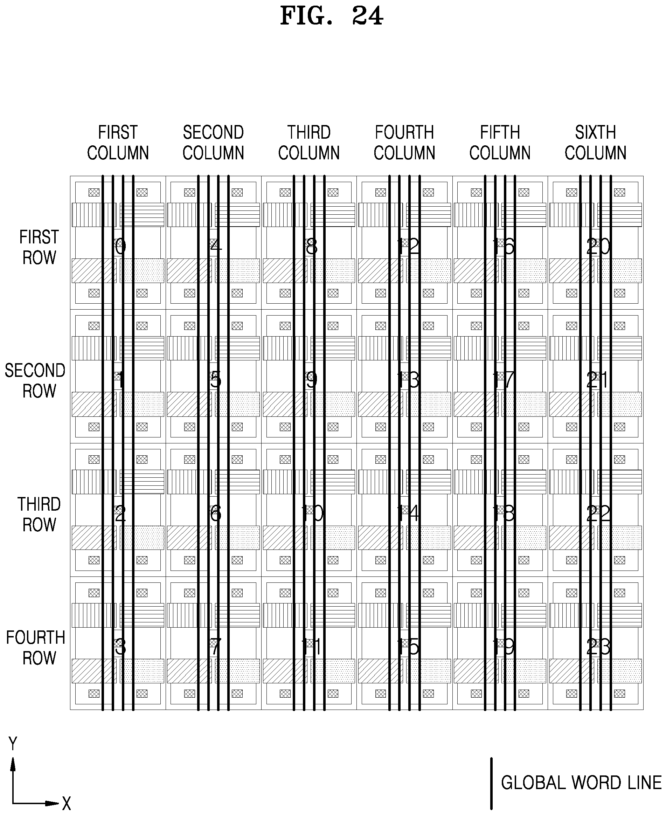

FIG. 24 is a diagram describing a connection structure between a semiconductor device and a global word line, according to one or more embodiments.

Referring to FIG. 24, four global word lines are connected to a plurality of semiconductor devices arranged in a first column, four global word lines are connected to a plurality of semiconductor devices arranged in a second column, four global word lines are connected to a plurality of semiconductor devices arranged in a third column, four global word lines are connected to a plurality of semiconductor devices arranged in a fourth column, four global word lines are connected to a plurality of semiconductor devices arranged in a fifth column, and four global word lines are connected to a plurality of semiconductor devices arranged in a sixth column. Global word lines may be respectively connected to corresponding semiconductor devices. According to one or more embodiments, the number of global word lines included in one column may correspond to the number of a plurality of semiconductor devices included in one column. Referring to FIG. 24, the number of a plurality of semiconductor devices included in one column may be four, and thus, the number of global word lines included in each column may also be four. According to one or more embodiments, wirings of global word lines included in each column may be arranged to cluster around a global word line node of an H-shaped active pattern.

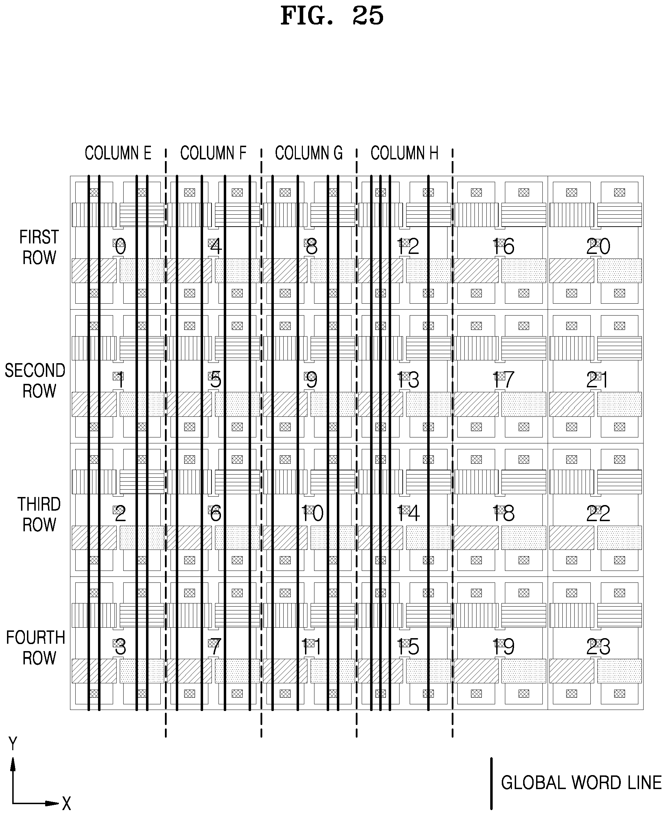

FIG. 25 is a diagram describing a connection structure between a semiconductor device and a global word line, according to one or more embodiments.

Referring to FIG. 25, an example in which global word lines are variously arranged in each column is shown. According to one or more embodiments, wirings of global word lines may be freely arranged in a line that does not interfere with the connection structure of local word lines.

Referring to a column E, global word lines may be arranged evenly on the left and right within the column E. Referring to a column F, global word lines may be arranged to have the same pitch within H-shaped active patterns. Referring to a column G, global word lines may be arranged with wide spacing on the left and narrow spacing on the right with respect to a central portion of the column G. Referring to a column H, with respect to a central portion of the column H, three global word lines may be arranged on the left, and one global word line may be arranged on the right.

According to one or more embodiments, in such a structure as in FIG. 24, a wiring of a global word line may be arranged in the center of an H-shaped active pattern, and a vertical wiring of a local word line may be arranged in the remaining region. In such a structure as in FIG. 25, a vertical wiring of a local word line may be arranged between wirings of a global word line.

In the column G and column H in FIG. 25, wirings of some global word lines are arranged adjacent to each other, but in such a case where wirings of global word lines are arranged adjacent to each other, a vertical wiring of a local word line may be arranged in a space between the wirings of global word lines adjacent to each other and the remaining wiring.

According to the embodiments of the present disclosure, when a plurality of semiconductor devices are arranged in parallel with each other in the first direction and the second direction, wirings of global word lines corresponding to the number of a plurality of semiconductor devices in a column direction and a wiring between local word lines within a corresponding column should be included within a pitch of an active region of one semiconductor device among the plurality of semiconductor devices, that is, the width obtained by adding the horizontal width of an H shape and a gap between H shapes. At this time, when the pitch of the active region of the semiconductor device is greater than the sum of pitches of the number of vertical metal wirings, vertical wirings may be used with individual tracks. According to one or more embodiments, some vertical wirings may share a track. According to one or more embodiments, a global word line passes through semiconductor devices in the entire column direction and may be wired as an individual track, and vertical wirings or horizontal wirings of local word lines may share a track.

According to the embodiments of the present disclosure, a semiconductor device that may be connected to word lines of a plurality of different blocks by using an active pattern having a shape other than a rectangle is shown. According to one or more embodiments, voltage environments at all positions may be the same based on a node of a word line to which a selected word line is connected. According to one or more embodiments, the surroundings, excluding the selected word line, may all be subjected to floating. According to the embodiments of the present disclosure, arrangements of pass transistors corresponding to four memory blocks may be arranged in basic repeating units. According to one or more embodiments, a wiring of a word line may be repeated in the same pattern for every four blocks. Accordingly, an active position for each word line may be freely connected.

A semiconductor device according to the embodiments of the present disclosure may have an H-shaped active region, and a plurality of isolated gate structures included in the semiconductor device may select different memory blocks, respectively. A plurality of semiconductor devices according to the embodiments of the present disclosure are arranged in parallel with each other in a second direction, and a vertical wiring structure for connection with other word lines in different blocks is shown. Therefore, it is possible to form a stack of a plurality of semiconductor devices, and various connection methods are possible, thereby increasing the degree of freedom in arrangement methods.

The foregoing exemplary embodiments are merely exemplary and are not to be construed as limiting. The present teaching can be readily applied to other types of apparatuses. Also, the description of the exemplary embodiments is intended to be illustrative, and not to limit the scope of the claims, and many alternatives, modifications, and variations will be apparent to those skilled in the art within the scope of the appended claims. Moreover, in the above description, in different embodiments, the same or equivalent elements may be denoted by different reference signs in various embodiments. For reasons of readability, not all of these reference signs may be introduced into the claims.

## Claims

1. A semiconductor device comprising:
a substrate (101) having an active region (110) comprising a central active region (110_1) and a plurality of separate active regions (110_2a, 110_2b, 110_2c, 110_2d) extending from the central active region (110_1); and
a plurality of gate structures (120a, 120b, 120c, 120d) disposed above the active region (110),
wherein the plurality of gate structures (120a, 120b, 120c, 120d), the central active region (110_1), and the plurality of separate active regions (110_2a, 110_2b, 110_2c, 110_2d) constitute a plurality of pass transistors (PTR1, PTR2, PTR3, PTR4), and
wherein the plurality of pass transistors (PTR1, PTR2, PTR3, PTR4) share a same source/drain region (D) in the central active region (110_1).

2. The semiconductor device of claim 1, wherein each of the plurality of gate structures (120a, 120b, 120c, 120d) has a rectangular shape or an L shape.

3. The semiconductor device of claim 1 or 2, wherein the active region (110) has an H shape, in which the central active region (110_1) has a rectangular shape, two of the plurality of separate active regions (110_2a, 110_2b, 110_2c, 110_2d) extend in one direction from the central active region (1 10_1) to be parallel to each other, and the other two of the plurality of separate active regions (110_2a, 110_2b, 110_2c, 110_2d) extend in an opposite direction from the central active region (110_1) to be parallel to each other.

4. The semiconductor device of claim 1 or 2, wherein the active region (110) has:
a cross shape in which the central active region (110_1b) has a rectangular shape and is posited at a midpoint of four outer points, and the plurality of separate active regions (110_2a2, 110_2b2, 110_2c2, 110_2d2) extend from the midpoint towards the four outer points, respectively, or
a Y shape in which the central active region (110_1c) has a triangle shape and is located at a midpoint of three corner points, and the plurality of separate active regions (110_2a3, 110_2b3, 110_2c3) extend from the midpoint towards the three corner points, respectively.

5. The semiconductor device of any one of claims 1 to 4, further comprising:
a drain contact (140) connected to the central active region (110_1); and
a plurality of source contacts (130a, 130b, 130c, 130d) of the plurality of pass transistors (PTR1, PTR2, PTR3, PTR4) respectively connected to the plurality of separate active regions (110_2a, 110_2b, 110_2c, 110_2d).

6. The semiconductor device of claim 5, wherein the drain contact (140) is connected to a global word line (GWL1), and
wherein the plurality of source contacts (130a, 130b, 130c, 130d) are connected to a plurality of different local word lines (LWL1, LWL2, LWL3, LWL4).

7. The semiconductor device of claim 6, wherein the plurality of source contacts (130a, 130b, 130c, 130d) are connected to different memory cell blocks (BLKO, BLK1, BLK2, BLK3), respectively.

8. A memory device comprising:
a plurality of memory blocks (BLKO to BLKi) comprising a plurality of memory cells connected to a plurality of word lines (WL) stacked in a vertical direction (Z); and
a plurality of pass transistor circuit blocks (12_0 to 12_n) connected to the plurality of memory blocks (BLKO to BLKi) and arranged in parallel with each other in a second horizontal direction (Y),
wherein each of the plurality of pass transistor circuit blocks (12_0 to 12_n) comprises a plurality of semiconductor devices (210, 220) arranged in parallel with each other in a first horizontal direction (X), and
wherein each of the plurality of semiconductor devices (210, 220) is a semiconductor device according to any one of claims 1 to 7.

9. The memory device of claim 8, wherein patterns of the plurality of semiconductor devices (210, 220, 230, 240) are identical within a same pass transistor circuit block among the plurality of pass transistor circuit blocks (12_0 to 12_n).

10. The memory device of claim 8 or 9, wherein patterns of semiconductor devices (212, 232) included in adjacent pass transistor circuit blocks (first row, second row) in the second horizontal direction (Y) among the plurality of pass transistor circuit blocks (12_0 to 12_n) are different from each other.

11. The memory device of any one of claims 8 to 10, wherein semiconductor devices included in adjacent pass transistor circuit blocks (first row, second row) that are adjacent to each other in the second horizontal direction (Y) among the plurality of pass transistor circuit blocks (12_0 to 12_n) are electrically connected to each other via a wiring in the second horizontal direction (Y) or in the first horizontal direction (X).

12. The memory device of any one of claims 8 to 11, wherein a global word line connected via a wiring in the second horizontal direction (Y) is connected to the source/drain regions (GA1, GA3) of the semiconductor devices (210; 230) included in each of the plurality of pass transistor circuit blocks (12_0 to 12_n) arranged adjacent to each other in the second horizontal direction (Y).

13. The memory device of any one of claims 8 to 12, wherein the plurality of pass transistor circuit blocks (12_0 to 12_n) are electrically connected to each other via a plurality of local word lines (LA1, LA2, LA3, LA4), respectively, among the plurality of word lines (WL).

14. A memory device comprising:
a plurality of memory cell blocks (BLKO to BLKi) arranged in parallel with each other in a second direction (Y); and
a plurality of semiconductor devices (210, 220, 230, 240) connected to the plurality of memory cell blocks,
wherein the plurality of semiconductor devices (210, 220, 230, 240) are arranged in parallel with each other in the second direction (Y), and N of the plurality of semiconductor devices (210, 220, 230, 240) are arranged in parallel with each other in a first direction (X), wherein N is a natural number that is greater than or equal to 1, and
wherein each of the plurality of semiconductor devices (210, 220, 230, 240) is a semiconductor device according to any one of claims 1 to 7.

15. The memory device of claim 14, wherein a global word line (GWL1) is connected to the source/drain region (GA1) of each (210) of the plurality of semiconductor devices (210, 220, 230, 240), and
wherein different local word lines (LW1, LW2, LW4, LW4) are connected to the plurality of separate active regions (110_2a, 110_2b, 110_2c, 110_2d) of each of the plurality of semiconductor devices (210; 220; 230; 240).
